# EUROPEAN PATENT APPLICATION

(11) **EP 4 697 600 A1**
(43) Date of publication of application: **18.02.2026**
(21) Application number: 24809988.9
(22) Date of filing: 26.02.2024
(51) Int. Cl.: H03K 17/00

(54) **SWITCH CIRCUIT, SWITCH APPLICATION SYSTEM, COMMUNICATION DEVICE, AND SWITCH APPLICATION METHOD**

(30) Priority: 23.05.2023 CN 202310595183
(71) Applicant: Honor Device Co., Ltd., Shenzhen, Guangdong 518040 (CN)
(72) Inventor: HUANG, Qinghua, Shenzhen, Guangdong 518040 (CN); LIU, Shumin, Shenzhen, Guangdong 518040 (CN); FENG, Baoxin, Shenzhen, Guangdong 518040 (CN)
(74) Representative: Isarpatent
(86) International application number: PCT/CN2024/078591
(87) International publication number: WO 2024/239739

(57) **Abstract**

Embodiments of this application relate to the field of communication technologies, and disclose a switch circuit, a switch application system, a communication device, and a switch application method, to reduce power consumption of the switch circuit. The switch circuit includes a first switch sub-circuit and a second switch sub-circuit that are connected in parallel. The first switch sub-circuit includes at least one first depletion-mode transistor that is connected in series. The second switch sub-circuit includes at least one first enhancement-mode transistor that is connected in series. The switch circuit includes a first terminal. The first switch sub-circuit includes a second terminal and a third terminal. The second switch sub-circuit includes a fourth terminal and a fifth terminal. The first terminal is electrically connected to the second terminal. The first terminal is electrically connected to the fourth terminal. The second terminal and the third terminal are connected and the fourth terminal and the fifth terminal are disconnected when the switch circuit is powered off.

## Description

This application claims priority to Chinese Patent Application No. 202310595183.5, filed with the China National Intellectual Property Administration on May 23, 2023 and entitled "SWITCH CIRCUIT, SWITCH APPLICATION SYSTEM, COMMUNICATION DEVICE, AND SWITCH APPLICATION METHOD", which is incorporated herein by reference in its entirety.

### TECHNICAL FIELD

This application relates to the field of communication technologies, and in particular, to a switch circuit, a switch application system, a communication device, and a switch application method.

### BACKGROUND

In a wireless communication network, a considerable part of energy of a communication device is wasted on idle listening (idle listening) during signal receiving. For this reason, in the conventional technology, a low-power wake-up radio (Low Power Wake Up Radio, LP-WUR for short) technology is used to reduce energy wasted during listening of a device.

A core idea of LP-WUR is that a wireless communication device (for example, a Bluetooth headset or a mobile phone) includes, in addition to a main communication module (for example, a wireless fidelity (wireless fidelity, Wi-Fi) module or a Bluetooth (Bluetooth, BT) module), a wake-up radio WUR module. When the main communication module is in a disabled state to save power consumption, the WUR module always operates in a wireless signal receiving state. When another communication device needs to communicate with the wireless communication device with the WUR module and the main communication module, the another communication device may send a wake-up frame to the WUR module. The WUR module may wake up the main communication module after determining that a wake-up sequence included in the wake-up frame is correct. The main communication module performs normal wireless signal receiving/transmitting after being awoken.

The WUR module and the main communication module may perform time division multiplexing on a same antenna. The antenna is separately connected to the WUR module and the main communication module through a single-pole double-throw switch. When the WUR module operates, a path that is in the single-pole multi-throw switch and that is connected between the antenna and the WUR module is controlled to be conductive, so that the WUR module receives the wake-up frame through the antenna. When the main communication module operates, a path that is in the single-pole multi-throw switch and that is connected between the antenna and the main communication module is controlled to be conductive, so that the main communication module performs wireless signal receiving/transmitting through the antenna.

In the conventional technology, in a process in which WUR performs signal listening, the single-pole multi-throw switch needs to be continuously powered, so that the path that is in the single-pole multi-throw switch and that is configured to be connected between WUR and the antenna is conductive, to further enable WUR to perform signal listening through the antenna. However, continuously supplying power to the single-pole multi-throw switch causes large power consumption.

### SUMMARY

Embodiments of this application provide a switch circuit, a switch application system, a communication device, and a switch application method, to reduce power consumption of the switch circuit.

To achieve the foregoing objective, the following technical solutions are used in embodiments of this application.

According to a first aspect, a switch circuit is provided. The switch circuit includes a first switch sub-circuit and a second switch sub-circuit that are connected in parallel. The first switch sub-circuit includes at least one first depletion-mode transistor that is connected in series. The second switch sub-circuit includes at least one first enhancement-mode transistor that is connected in series. The switch circuit includes a first terminal. The first switch sub-circuit includes a second terminal and a third terminal. The second switch sub-circuit includes a fourth terminal and a fifth terminal. The first terminal is electrically connected to the second terminal. The first terminal is electrically connected to the fourth terminal.

The second terminal and the third terminal are connected and the fourth terminal and the fifth terminal are disconnected when the switch circuit is powered off.

It can be understood that the switch circuit includes the first switch sub-circuit and the second switch sub-circuit that are connected in parallel. The first switch sub-circuit includes the at least one first depletion-mode transistor that is connected in series, and the first depletion-mode transistor may still be turned on when being powered off. Therefore, it can be learned that the second terminal and the third terminal of the first switch sub-circuit are connected when the switch circuit is powered off (including a case that the first switch sub-circuit is powered off). The first terminal of the switch circuit is electrically connected to the second terminal. Therefore, when the second terminal and the third terminal are connected, the first terminal of the switch circuit and the third terminal are also connected, so that a conductive path is provided without the switch circuit consuming any power, thereby reducing power consumption of the switch circuit.

With reference to the first aspect, in a possible implementation, when a voltage at a control terminal of the at least one first depletion-mode transistor is a first voltage value and a voltage at a control terminal of the at least one first enhancement-mode transistor is a second voltage value, the second terminal and the third terminal are disconnected, and the fourth terminal and the fifth terminal are connected.

It can be understood that the first switch sub-circuit may include a plurality of first depletion-mode transistors that are connected in series. When voltages of the plurality of first depletion-mode transistors that are connected in series are all the first voltage value, the plurality of first depletion-mode transistors are all turned off, and the second terminal and the third terminal are disconnected. The first terminal of the switch circuit is electrically connected to the second terminal. Therefore, it can be learned that, when the second terminal and the third terminal are disconnected, the first terminal and the third terminal are also disconnected. Because there are the plurality of first depletion-mode transistors that are turned off between the first terminal and the third terminal, a possibility that a wireless signal is transmitted from the first terminal of the switch circuit to the third terminal is smaller. The plurality of first depletion-mode transistors that are connected in series may implement signal isolation at the third terminal when the first terminal and the third terminal of the switch circuit are disconnected.

With reference to the first aspect, in another possible implementation, the first terminal of the switch circuit is configured to be electrically connected to an antenna, the third terminal is configured to be electrically connected to a first wake-up receiver WUR, and the fifth terminal is configured to be electrically connected to a first communication module.

It can be understood that the first terminal of the switch circuit may be electrically connected to the antenna, the third terminal of the switch circuit may be electrically connected to the first WUR, and the fifth terminal may be electrically connected to the first communication module. Because the first terminal is electrically connected to the second terminal of the first switch sub-circuit and is further electrically connected to the fourth terminal of the second switch sub-circuit, it can be learned that, when the first terminal is connected to the antenna, the second terminal and the fourth terminal are also connected to the antenna. Then, because the second terminal and the third terminal of the first switch sub-circuit are connected when the switch circuit is powered off (including the case that the first switch sub-circuit is powered off), it can be learned that the first WUR may be connected to the antenna through the first switch sub-circuit when the switch circuit is powered off (including the case that the first switch sub-circuit is powered off). The second switch sub-circuit includes the at least one first enhancement-mode transistor that is connected in series, and the first enhancement-mode transistor is turned off when being powered off. Therefore, it can be learned that the fourth terminal and the fifth terminal of the second switch sub-circuit are disconnected when the switch circuit is powered off (including a case that the second switch sub-circuit is powered off). Because the fourth terminal and the fifth terminal of the second switch sub-circuit are disconnected when the switch circuit is powered off (including the case that the second switch sub-circuit is powered off), it can be learned that the first communication device is disconnected from the antenna when the switch circuit is powered off (including the case that the second switch sub-circuit is powered off).

In conclusion, it can be learned that the antenna is connected to the first WUR through the switch circuit and is disconnected from the first communication module when the switch circuit is powered off (including the case that the first switch sub-circuit is powered off and the case that the second switch sub-circuit is powered off). Therefore, the first WUR may perform wireless signal listening through the antenna, and the first communication module is in a disabled state and does not receive a wireless signal. Because power consumption of performing wireless signal listening by the first WUR through the antenna is small, and there is no power consumption when the switch circuit is powered off, power consumption of a wireless signal listening process can be reduced.

With reference to the first aspect, in another possible implementation, the first terminal of the switch circuit is configured to be electrically connected to a television set, the second terminal of the switch circuit is configured to be electrically connected to an antenna, and the third terminal of the switch circuit is configured to be electrically connected to a multimedia player.

It can be understood that the first terminal and the third terminal are connected and the first terminal and the fifth terminal are disconnected when the switch circuit is powered off. Therefore, it can be learned that the television set is electrically connected to the antenna and the television set is disconnected from the multimedia player when the switch circuit is powered off. Therefore, the television set performs signal receiving through the antenna without the switch circuit consuming any power.

With reference to the first aspect, in another possible implementation, the switch circuit further includes a third switch sub-circuit, and the third switch sub-circuit is connected in parallel to the first switch sub-circuit and the second switch sub-circuit. The third switch sub-circuit includes a sixth terminal and a seventh terminal. The first terminal is electrically connected to the sixth terminal. The third switch sub-circuit includes at least one second depletion-mode transistor that is connected in series.

The sixth terminal and the seventh terminal are connected when the switch circuit is powered off, and the sixth terminal and the seventh terminal are disconnected when a voltage at a control terminal of the at least one second depletion-mode transistor is the first voltage value.

It can be understood that both the first switch sub-circuit and the third switch sub-circuit in the switch circuit are turned on when being powered off, and the second terminal and the third terminal are connected when the first switch sub-circuit is turned on and the sixth terminal and the seventh terminal are connected when the third switch sub-circuit is turned on. Therefore, it can be learned that a plurality of conductive paths (including a path from the second terminal to the third terminal and a path from the sixth terminal to the seventh terminal) may be provided when the switch circuit is powered off, that is, a plurality of conductive paths may be provided without the switch circuit consuming any power. Because the first terminal is electrically connected to the second terminal, when the second terminal and the third terminal are connected, the first terminal and the third terminal are also connected. Because the first terminal is electrically connected to the sixth terminal, when the sixth terminal and the seventh terminal are connected, the first terminal and the seventh terminal are also connected.

With reference to the first aspect, in another possible implementation, the seventh terminal is configured to be electrically connected to a second WUR, and an operating frequency band of the second WUR is different from that of the first WUR.

It can be understood that, when the switch circuit is powered off, both the at least one first depletion-mode transistor and the at least one second depletion-mode transistor are turned on, and the at least one first enhancement-mode transistor is turned off. When both the at least one first depletion-mode transistor and the at least one second depletion-mode transistor are turned on, the first terminal and the third terminal are connected, and the first terminal and the seventh terminal are also connected. In this case, both the first WUR and the second WUR are connected to a same antenna. Therefore, the first WUR and the second WUR may simultaneously perform wireless signal listening, so that a plurality of WURs with different operating frequency bands perform wireless signal listening without the switch circuit consuming any power.

With reference to the first aspect, in another possible implementation, the switch circuit further includes a fourth switch sub-circuit, and the fourth switch sub-circuit is connected in parallel to the first switch sub-circuit and the second switch sub-circuit. The fourth switch sub-circuit includes an eighth terminal and a ninth terminal. The first terminal is electrically connected to the eighth terminal. The fourth switch sub-circuit includes at least one second enhancement-mode transistor that is connected in series.

The eighth terminal and the ninth terminal are disconnected when the switch circuit is powered off, and the eighth terminal and the ninth terminal are connected when a voltage at a control terminal of the at least one second enhancement-mode transistor is the second voltage value.

It can be understood that the first terminal is electrically connected to the eighth terminal. Therefore, when the eighth terminal and the ninth terminal are disconnected, the first terminal and the ninth terminal are also disconnected; and when the eighth terminal and the ninth terminal are connected, the first terminal and the ninth terminal are also connected.

With reference to the first aspect, in another possible implementation, the ninth terminal of the switch circuit is configured to be connected to a second communication module.

It can be understood that, in addition to the second switch sub-circuit including an enhancement-mode transistor, the switch circuit may further include the fourth switch sub-circuit including an enhancement-mode transistor. A path in the second switch sub-circuit and the fourth switch sub-circuit may be conductive by controlling the switch circuit to be powered on, so that the first communication module connected to the second switch sub-circuit is connected to the antenna, or the second communication module connected to the fourth switch sub-circuit is connected to the antenna.

With reference to the first aspect, in another possible implementation, the first switch sub-circuit includes a first branch circuit, and the first branch circuit includes at least one third enhancement-mode transistor that is connected in series. The first branch circuit includes a tenth terminal and an eleventh terminal. The tenth terminal is electrically connected to the first switch sub-circuit, and the eleventh terminal is grounded. The tenth terminal and the eleventh terminal are disconnected when the switch circuit is powered off, and the tenth terminal and the eleventh terminal are connected when a voltage at a control terminal of the at least one third enhancement-mode transistor is the second voltage value.

It can be understood that, when the voltage at the control terminal of the at least one first depletion-mode transistor is the first voltage value, and both the voltage at the control terminal of the at least one first enhancement-mode transistor and the voltage at the control terminal of the at least one third enhancement-mode transistor are the second voltage value, the at least one first depletion-mode transistor is turned off, the at least one first enhancement-mode transistor is turned on, and the at least one third enhancement-mode transistor is turned on. If the at least one first depletion-mode transistor is turned off, the second terminal and the third terminal of the first switch sub-circuit (including the at least one first depletion-mode transistor that is connected in series) are disconnected, and the first terminal and the third terminal of the switch circuit are also disconnected. If the at least one first enhancement-mode transistor is turned on, the fourth terminal and the fifth terminal of the second switch sub-circuit (including the at least one first enhancement-mode transistor that is connected in series) are connected, and the first terminal and the fifth terminal of the switch circuit are also connected. If the at least one third enhancement-mode transistor is turned on, the tenth terminal and the eleventh terminal of the first branch circuit are also connected, and the tenth terminal of the first branch circuit is grounded.

Therefore, if some wireless signals are still leaked and transmitted from the second terminal to the third terminal of the first switch sub-circuit when the second terminal and the third terminal of the first switch sub-circuit are disconnected, because the first switch sub-circuit is connected to the grounded first branch circuit, the leaked wireless signals may be transmitted to the ground through the grounded first branch circuit, instead of being transmitted from the second terminal to the third terminal of the first switch sub-circuit. That is, the first branch circuit may enhance signal isolation at the third terminal of the first switch sub-circuit when the first switch sub-circuit is turned off.

With reference to the first aspect, in another possible implementation, the second switch sub-circuit includes a second branch circuit, and the second branch circuit includes at least one third depletion-mode transistor that is connected in series. The second branch circuit includes a twelfth terminal and a thirteenth terminal. The twelfth terminal is electrically connected to the second switch sub-circuit, and the thirteenth terminal is grounded. The twelfth terminal and the thirteenth terminal are connected when the switch circuit is powered off, and the twelfth terminal and the thirteenth terminal are disconnected when a voltage at a control terminal of the at least one third depletion-mode transistor is the first voltage value.

It can be understood that, when the switch circuit is powered off, the at least one first depletion-mode transistor is turned on, the at least one first enhancement-mode transistor is turned off, and the at least one third depletion-mode transistor is turned on. If the at least one first depletion-mode transistor is turned on, the second terminal and the third terminal of the first switch sub-circuit (including the at least one first depletion-mode transistor that is connected in series) are connected, and the first terminal and the second terminal of the switch circuit are also connected. If the at least one first enhancement-mode transistor is turned off, the fourth terminal and the fifth terminal of the second switch sub-circuit (including the at least one first enhancement-mode transistor that is connected in series) are disconnected, and the first terminal and the fifth terminal of the switch circuit are also disconnected. If the at least one third depletion-mode transistor is turned on, the twelfth terminal and the thirteenth terminal of the second branch circuit are also connected, and the twelfth terminal is grounded.

Therefore, if some wireless signals are still leaked and transmitted from the fourth terminal to the fifth terminal of the second switch sub-circuit when the fourth terminal and the fifth terminal of the second switch sub-circuit are disconnected, because the second switch sub-circuit is connected to the grounded second branch circuit, the leaked wireless signals may be transmitted to the ground through the grounded second branch circuit, instead of being transmitted from the fourth terminal to the fifth terminal of the second switch sub-circuit. That is, the second branch circuit may enhance signal isolation at the fifth terminal of the second switch sub-circuit when the second switch sub-circuit is turned off.

According to a second aspect, a switch application system is provided. The switch application system includes a first signal transceiver module, a second signal transceiver module, a third signal transceiver module, and a switch circuit. The switch circuit includes a first terminal. The switch circuit includes a first switch sub-circuit and a second switch sub-circuit that are connected in parallel, the first switch sub-circuit includes at least one first depletion-mode transistor that is connected in series, and the second switch sub-circuit includes at least one first enhancement-mode transistor that is connected in series. The first switch sub-circuit includes a second terminal and a third terminal, and the second switch sub-circuit includes a fourth terminal and a fifth terminal. The first terminal is electrically connected to the second terminal, and the first terminal is electrically connected to the fourth terminal. The first terminal is electrically connected to the first signal transceiver module, the third terminal is electrically connected to the second signal transceiver module, and the fifth terminal is electrically connected to the third signal transceiver module.

The second signal transceiver module is configured to perform signal transmission with the first signal transceiver module through the switch circuit when the switch circuit is powered off. The third signal transceiver module is configured to perform signal transmission with the first signal transceiver module through the switch circuit when the at least one first depletion-mode transistor and the at least one first enhancement-mode transistor are powered on.

The second terminal and the third terminal are connected and the fourth terminal and the fifth terminal are disconnected when the switch circuit is powered off. When a preset power-on condition is met, the at least one first depletion-mode transistor and the at least one first enhancement-mode transistor are powered on. The fourth terminal and the fifth terminal are connected when the at least one first depletion-mode transistor and the at least one first enhancement-mode transistor are powered on.

With reference to the second aspect, in a possible implementation, the first signal transceiver module is a television set, the second signal transceiver module is an antenna, and the third signal transceiver module is a multimedia player. The preset power-on condition includes a switching operation, and the switching operation is used to trigger switching for a signal source of the television set.

The television set is configured to: when the switch circuit is powered off, receive a first signal through the switch circuit and the antenna, and display first multimedia information according to the first signal; and receive the switching operation, control, in response to the switching operation, the at least one first depletion-mode transistor and the at least one first enhancement-mode transistor to be powered on, receive a second signal through the switch circuit and the multimedia player, and display second multimedia information according to the second signal.

With reference to the second aspect, in another possible implementation, the first signal transceiver module is an antenna, the second signal transceiver module is a first WUR, and the third signal transceiver module is a first communication module. The preset power-on condition includes a case that the first communication module enters an operating mode.

The first WUR is configured to: receive a first wireless signal through the switch circuit and the antenna when the switch circuit is powered off; and when the first wireless signal is a first wake-up signal, wake up the first communication module in response to the first wake-up signal, so that the first communication module enters the operating mode. The first communication module is configured to: in the operating mode, control the at least one first depletion-mode transistor and the at least one first enhancement-mode transistor to be powered on, and receive a second wireless signal through the switch circuit and the antenna.

With reference to the second aspect, in another possible implementation, the first communication module is electrically connected to a control terminal of the at least one first depletion-mode transistor, and the first communication module is electrically connected to a control terminal of the at least one first enhancement-mode transistor The first communication module is specifically configured to: in the operating mode, output a first voltage value to the control terminal of the at least one first depletion-mode transistor, and output a second voltage value to the control terminal of the at least one first enhancement-mode transistor, so that the second terminal and the third terminal of the first switch sub-circuit are disconnected, and the fourth terminal and the fifth terminal of the second switch sub-circuit are connected.

With reference to the second aspect, in another possible implementation, the first communication module is further configured to enter a sleep state when a sleep condition is met, where the at least one first depletion-mode transistor and the at least one first enhancement-mode transistor are powered off when the first communication module is in the sleep state.

With reference to the second aspect, in another possible implementation, the switch circuit further includes a third switch sub-circuit, and the third switch sub-circuit is connected in parallel to the first switch sub-circuit and the second switch sub-circuit. The third switch sub-circuit includes a sixth terminal and a seventh terminal. The first terminal of the switch circuit is electrically connected to the sixth terminal. The third switch sub-circuit includes at least one second depletion-mode transistor that is connected in series. The sixth terminal and the seventh terminal are connected when the switch circuit is powered off.

With reference to the second aspect, in another possible implementation, the switch application system further includes a second WUR, the seventh terminal is electrically connected to the second WUR, and an operating frequency band of the second WUR is different from that of the first WUR. The second WUR is configured to: receive a third wireless signal through the switch circuit and the antenna when the switch circuit is powered off; and when the third wireless signal is a third wake-up signal, wake up the first communication module in response to the third wake-up signal, so that the first communication module enters the operating mode.

With reference to the second aspect, in another possible implementation, the first communication module is electrically connected to the control terminal of the at least one first depletion-mode transistor, the first communication module is electrically connected to the control terminal of the at least one first enhancement-mode transistor, and the first communication module is electrically connected to a control terminal of the at least one second depletion-mode transistor. The first communication module is specifically configured to: in the operating mode, output the first voltage value to the control terminal of the at least one first depletion-mode transistor and the control terminal of the at least one second depletion-mode transistor, and output the second voltage value to the control terminal of the control terminal of the at least one first enhancement-mode transistor, so that the second terminal and the third terminal of the first switch sub-circuit are disconnected, the sixth terminal and the seventh terminal of the third switch sub-circuit are disconnected, and the fourth terminal and the fifth terminal of the second switch sub-circuit are connected.

With reference to the second aspect, in another possible implementation, the switch application system further includes a second communication module. The switch circuit further includes a fourth switch sub-circuit. The fourth switch sub-circuit is connected in parallel to the first switch sub-circuit and the second switch sub-circuit. The fourth switch sub-circuit includes an eighth terminal and a ninth terminal. The first terminal of the switch circuit is electrically connected to the eighth terminal. The ninth terminal is electrically connected to the second communication module. The fourth switch sub-circuit includes at least one second enhancement-mode transistor that is connected in series.

The first WUR is further configured to: when the first wireless signal is a second wake-up signal, wake up the second communication module in response to the second wake-up signal, so that the second communication module enters an operating mode. The second communication module is configured to: in the operating mode, control the at least one first depletion-mode transistor and the at least one second enhancement-mode transistor to be powered on, and receive the third wireless signal through the switch circuit and the antenna.

The eighth terminal and the ninth terminal are disconnected when the switch circuit is powered off, and the eighth terminal and the ninth terminal are connected when the at least one first depletion-mode transistor and the at least one second enhancement-mode transistor are powered on.

With reference to the second aspect, in another possible implementation, the first switch sub-circuit includes a first branch circuit, and the first branch circuit includes at least one third enhancement-mode transistor that is connected in series. The first branch circuit includes a tenth terminal and an eleventh terminal. The tenth terminal is electrically connected to the first switch sub-circuit, and the eleventh terminal is grounded. The first communication module is electrically connected to a control terminal of the at least one third enhancement-mode transistor. The first communication module is further configured to: in the operating mode, output the second voltage value to the control terminal of the at least one third enhancement-mode transistor, so that the tenth terminal and the eleventh terminal are connected.

The tenth terminal and the eleventh terminal are disconnected when the switch circuit is powered off.

With reference to the second aspect, in another possible implementation, the second switch sub-circuit includes a second branch circuit, and the second branch circuit includes at least one third depletion-mode transistor that is connected in series. The second branch circuit includes a twelfth terminal and a thirteenth terminal. The twelfth terminal is electrically connected to the second switch sub-circuit, and the thirteenth terminal is grounded. The first communication module is electrically connected to a control terminal of the at least one third depletion-mode transistor. The first communication module is further configured to: in the operating mode, output the first voltage value to the control terminal of the at least one third depletion-mode transistor, so that the twelfth terminal and the thirteenth terminal are disconnected. The twelfth terminal and the thirteenth terminal are connected when the switch circuit is powered off.

According to a third aspect, a communication device is provided. The communication device includes the switch application system according to any one of the second aspect and/or the switch circuit according to any one of the first aspect.

According to a fourth aspect, a switch application method is provided and applied to a switch application system. The switch application system includes a first signal transceiver module, a second signal transceiver module, a third signal transceiver module, and a switch circuit. The switch circuit includes a first terminal. The switch circuit includes a first switch sub-circuit and a second switch sub-circuit that are connected in parallel, the first switch sub-circuit includes at least one first depletion-mode transistor that is connected in series, and the second switch sub-circuit includes at least one first enhancement-mode transistor that is connected in series. The first switch sub-circuit includes a second terminal and a third terminal, and the second switch sub-circuit includes a fourth terminal and a fifth terminal. The first terminal is electrically connected to the second terminal, and the first terminal is electrically connected to the fourth terminal. The first terminal is electrically connected to the first signal transceiver module, the third terminal is electrically connected to the second signal transceiver module, and the fifth terminal is electrically connected to the third signal transceiver module. The method includes: The second signal transceiver module performs signal transmission with the first signal transceiver module through the switch circuit when the switch circuit is powered off; and when a preset power-on condition is met, the at least one first depletion-mode transistor and the at least one first enhancement-mode transistor are controlled to be powered on, and the third signal transceiver module performs signal transmission with the first signal transceiver module through the switch circuit.

The second terminal and the third terminal are connected and the fourth terminal and the fifth terminal are disconnected when the switch circuit is powered off, and the fourth terminal and the fifth terminal are connected when the at least one first depletion-mode transistor and the at least one first enhancement-mode transistor are powered on.

With reference to the fourth aspect, in a possible implementation, the first signal transceiver module is an antenna, the second signal transceiver module is a first WUR, the third signal transceiver module is a first communication module, and the preset power-on condition includes a case that the first communication module enters an operating mode. The method includes: When the switch circuit is powered off, the first WUR receives a first wireless signal through the switch circuit and the antenna, and when the first wireless signal is a first wake-up signal, sends a first wake-up instruction to the first communication module in response to the first wake-up signal; the first communication module enters the operating mode in response to the first wake-up instruction, and controls the at least one first depletion-mode transistor and the at least one first enhancement-mode transistor to be powered on, so that the second terminal and the third terminal are disconnected, and the fourth terminal and the fifth terminal are connected; and the first communication module receives a second wireless signal through the switch circuit and the antenna.

With reference to the fourth aspect, in another possible implementation, the method further includes: The first communication module enters a sleep state when a sleep condition is met, where the at least one first depletion-mode transistor and the at least one first enhancement-mode transistor are powered off when the first communication module is in the sleep state.

With reference to the fourth aspect, in another possible implementation, the first signal transceiver module is a television set, the second signal transceiver module is an antenna, the third signal transceiver module is a multimedia player, the preset power-on condition includes a switching operation, and the switching operation is used to trigger switching for a signal source of the television set. The method includes: When the switch circuit is powered off, the television set receives a first signal through the switch circuit and the antenna, and displays first multimedia information according to the first signal; the television set receives the switching operation, controls, in response to the switching operation, the at least one first depletion-mode transistor and the at least one first enhancement-mode transistor to be powered on, and receives a second signal through the switch circuit and the multimedia player; and the television set displays second multimedia information according to the second signal.

According to a fifth aspect, a communication device is provided. The communication device includes a processor, a memory, a communication interface, and a communication bus. The processor, the memory, and the communication interface communicate with each other through the communication bus. The memory is configured to store computer instructions. When the computer instructions are run on the processor, the processor is enabled to perform the switch application method according to any one of the fourth aspect.

According to a sixth aspect, a computer-readable storage medium is provided. The computer-readable storage medium stores computer instructions. When the computer instructions are run on a communication device, the communication device is enabled to perform the switch application method according to any one of the fourth aspect.

According to a seventh aspect, a computer program product including computer instructions is provided. When the computer instructions are run on a communication device, the communication device is enabled to perform the switch application method according to any one of the fourth aspect.

It should be understood that, for technical effects brought by any one of design manners in the second aspect to the seventh aspect, refer to the technical effects brought by different design manners in the first aspect. Details are not described herein again.

### BRIEF DESCRIPTION OF DRAWINGS

FIG. 1 is a diagram of a structure of a communication device according to a related solution;
FIG. 2 is a diagram of a structure of another communication device according to a related solution;
FIG. 3 is a diagram 1 of a structure of a switch circuit according to an embodiment of this application;
FIG. 4 is a schematic diagram of a cross-sectional structure and control of a depletion-mode NMOS transistor according to an embodiment of this application;
FIG. 5 is a schematic diagram of a cross-sectional structure and control of an enhancement-mode NMOS transistor according to an embodiment of this application;
FIG. 6 is a diagram 3 of a structure of a switch circuit according to an embodiment of this application;
FIG. 7A is a diagram 4 of a structure of a switch circuit according to an embodiment of this application;
FIG. 7B is a diagram 5 of a structure of a switch circuit according to an embodiment of this application;
FIG. 8A is a diagram 6 of a structure of a switch circuit according to an embodiment of this application;
FIG. 8B is a diagram 7 of a structure of a switch circuit according to an embodiment of this application;
FIG. 9 is a diagram 8 of a structure of a switch circuit according to an embodiment of this application;
FIG. 10A is a diagram 9 of a structure of a switch circuit according to an embodiment of this application;
FIG. 10B is a diagram 10 of a structure of a switch circuit according to an embodiment of this application;
FIG. 10C is a diagram 11 of a structure of a switch circuit according to an embodiment of this application;
FIG. 11A is a diagram 1 of a structure of a switch application system according to an embodiment of this application;
FIG. 11B is a diagram 2 of a structure of a switch application system according to an embodiment of this application;
FIG. 12 is a diagram of a structure of a first communication module according to an embodiment of this application;
FIG. 13A is a flowchart 1 of a switch application method according to an embodiment of this application;
FIG. 13B is a flowchart 2 of a switch application method according to an embodiment of this application;
FIG. 14 is a diagram 2 of a structure of a switch circuit according to an embodiment of this application; and
FIG. 15 is a schematic diagram of a hardware structure of a communication device according to an embodiment of this application.

### DESCRIPTION OF EMBODIMENTS

The following clearly and completely describes the technical solutions in embodiments of this application with reference to the accompanying drawings in embodiments of this application. Clearly, the described embodiments are merely some rather than all of embodiments of this application. Based on embodiments of this application, all other embodiments obtained by a person of ordinary skill in the art without creative efforts fall within the protection scope of this application.

In the following, the terms "first" and "second" are used merely for the purpose of description, and shall not be construed as indicating or implying relative importance or implicitly indicating a quantity of indicated technical features. Therefore, a feature limited by "first" or "second" may explicitly or implicitly include one or more features. In the description of this application, unless otherwise stated, "a plurality of" means two or more.

In addition, in embodiments of this application, one terminal X1 of one element X being "electrically connected" to one terminal Y1 of another element Y may refer to a circuit connection indicating that the terminal X1 of the element X is in physical contact with the terminal Y1 of the element Y, for example, a wire connection.

Currently, to reduce power consumption of a communication device, a related solution provides an LP-WUR technology. A core idea of the LP-WUR technology is that, in addition to a main communication module, a communication device further includes a WUR module. When the communication device does not need to communicate with another communication device, the main communication module enters a sleep state, the WUR module operates, and the WUR module is configured to perform wireless signal listening. Because power consumption of the WUR module is less than power consumption of the main communication module, performing signal listening by the WUR module can reduce power consumption of the communication device. If the WUR module detects a wireless signal sent by the another communication device, and determines that the wireless signal is used to trigger wake-up for the main communication module, the WUR module may wake up the main communication module, so that the main communication module switches from the sleep state to an operating mode. The main communication module may perform wireless signal receiving/transmission in the operating mode.

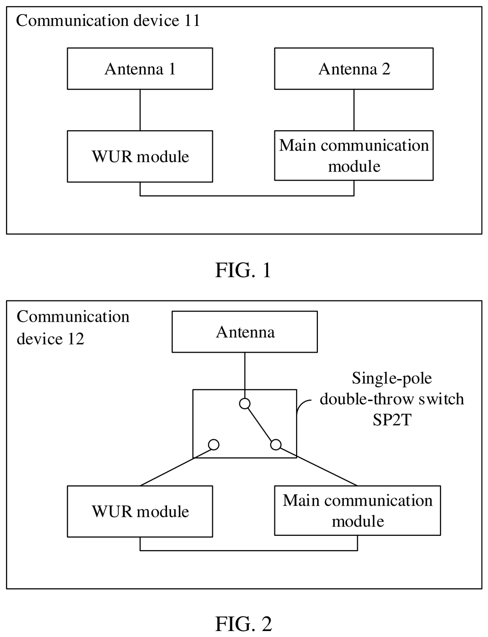

For example, FIG. 1 is a diagram of a structure of a communication device according to a related solution. A communication device 11 includes a WUR module, a main communication module, an antenna 1, and an antenna 2. The main communication module is electrically connected to the antenna 1, the WUR module is electrically connected to the antenna 2, and the WUR module is electrically connected to the main communication module. When the main communication module is in a sleep state, the WUR module performs wireless signal listening through the antenna 2. If the WUR module receives a wake-up sequence through the antenna, and determines that the wake-up sequence is used to trigger wake-up for the main communication module, the main communication module is awoken. The main communication module is awoken to enter an operating mode. The main communication module performs wireless signal receiving/transmitting through the antenna 2 when being in the operating mode.

Further, to reduce area overheads of the communication device, the related solution proposes that the WUR module and the main communication module perform time division multiplexing on a same antenna.

For example, FIG. 2 is a diagram of a structure of a communication device according to a related solution. A communication device 12 includes a WUR module, a main communication module, a single-pole double-throw switch SP2T, and an antenna. A first terminal of the SP2T is electrically connected to the antenna, a second terminal of the SP2T is electrically connected to the WUR module, and a second terminal of the SP2T is electrically connected to the main communication module.

When the main communication module enters a sleep state, the communication device 12 controls the SP2T to be powered on, so that the first terminal of the SP2T and the second terminal of the SP2T are connected, and the first terminal of the SP2T and the third terminal of the SP2T are disconnected. When the first terminal of the SP2T and the second terminal of the SP2T are connected and the first terminal of the SP2T and the third terminal of the SP2T are disconnected, the main communication module is disconnected from the antenna, the WUR module is connected to the antenna, and the WUR module may perform wireless signal listening through the antenna. Further, if the WUR module wakes up the main communication module, the main communication module enters an operating mode. In this case, the communication device 12 may control the SP2T to be powered on, so that the first terminal of the SP2T and the second terminal of the SP2T are disconnected, and the first terminal of the SP2T and the third terminal of the SP2T are connected. When the first terminal of the SP2T and the second terminal of the SP2T are disconnected, and the first terminal of the SP2T and the third terminal of the SP2T are connected, the WUR module is disconnected from the antenna, the main communication module is connected to the antenna, and the main communication module may communicate with another communication device through the antenna.

It can be learned that, when the main communication module is in the sleep state, the communication device 12 controls the SP2T to be powered on, so that the first terminal of the SP2T and the second terminal of the SP2T are connected, to further enable the WUR module to perform wireless signal listening through the antenna. Although power consumption of the WUR module is small during wireless signal listening, the communication device 12 needs to always control the SP2T to be powered on. Power consumption caused when the communication device 12 controls the SP2T to be powered on results in an increase in power consumption in a process of performing wireless signal listening by the WUR.

For the foregoing problems, an embodiment of this application provides a switch circuit. The switch circuit includes a first switch sub-circuit and a second switch sub-circuit that are connected in parallel. Both a second terminal of the first switch sub-circuit and a fourth terminal of the second switch sub-circuit may be connected to an antenna, a third terminal of the first switch sub-circuit may be connected to a WUR, and a fifth terminal of the second switch sub-circuit may be connected to a first communication module. The first switch sub-circuit includes at least one first depletion-mode transistor that is connected in series, and the first depletion-mode transistor is turned on when being powered off. Therefore, it can be learned that the second terminal and the third terminal of the first switch sub-circuit are connected when the first switch sub-circuit is powered off, and the WUR may still be connected to the antenna through the first switch sub-circuit when the first switch sub-circuit is powered off. The second switch sub-circuit includes at least one first enhancement-mode transistor that is connected in series, and the first enhancement-mode transistor is turned off when being powered off. Therefore, it can be learned that the fourth terminal and the fifth terminal of the second switch sub-circuit are disconnected when the second switch sub-circuit is powered off, and the first communication device is also disconnected from the antenna when the second switch sub-circuit is powered off.

In conclusion, it can be learned that, when the switch circuit is powered off (including a case that the first switch sub-circuit is powered off and a case that the second switch sub-circuit is powered off), the antenna is connected to the WUR through the switch circuit, and is disconnected from the first communication module. Therefore, the WUR may perform wireless signal listening through the antenna, and the first communication module is in a sleep state and does not receive a wireless signal. Because power consumption is small when the WUR performs wireless signal listening through the antenna, and there is no power consumption when the switch circuit is powered off, power consumption in a process of performing wireless signal listening can be reduced.

The following describes, with reference to the accompanying drawings, a switch circuit, a switch application system including the switch circuit, a communication device, and a switch application method applied to the communication device that are provided in the embodiments of this application.

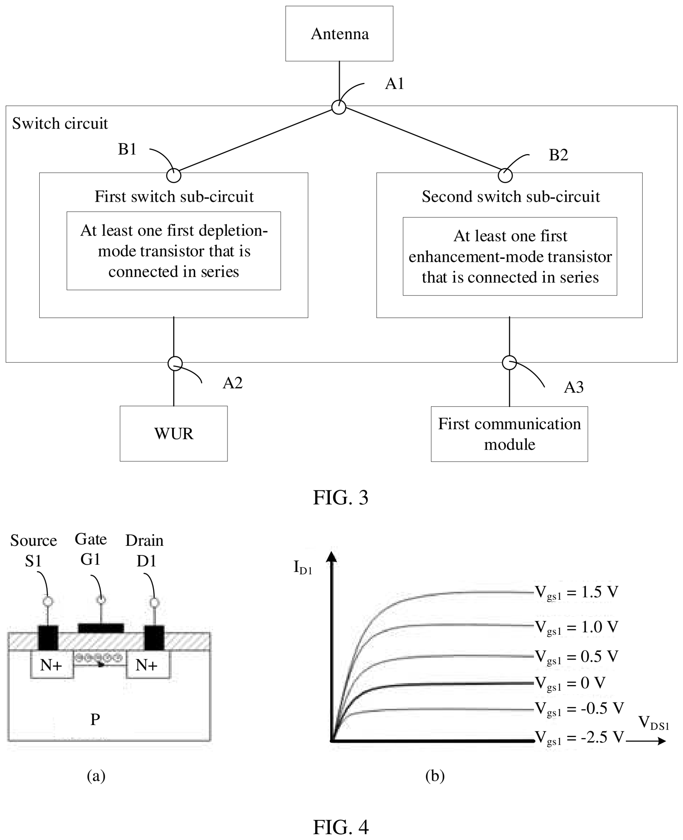

FIG. 3 shows a switch circuit according to an embodiment of this application. As shown in FIG. 3, the switch circuit includes a first switch sub-circuit and a second switch sub-circuit that are connected in parallel. The first switch sub-circuit includes at least one first depletion-mode transistor that is connected in series, and the second switch sub-circuit includes at least one first enhancement-mode transistor that is connected in series. The switch circuit includes a first terminal A1, the first switch sub-circuit includes a second terminal B1 and a third terminal A2, and the second switch sub-circuit includes a fourth terminal B2 and a fifth terminal A3. The first terminal A1 is electrically connected to the second terminal B 1, and the first terminal A1 is electrically connected to the fourth terminal B2. The second terminal B1 and the third terminal A2 of the first switch sub-circuit are two terminals of the at least one first depletion-mode transistor that is connected in series, and the fourth terminal B2 and the fifth terminal A3 of the second switch sub-circuit are two terminals of the at least one first enhancement-mode transistor that is connected in series.

The second terminal B1 and the third terminal A2 are connected and the second terminal B1 and the fifth terminal A3 are disconnected when the switch circuit is powered off. The second terminal B1 and the third terminal A2 are disconnected and the second terminal B1 and the fifth terminal A3 are connected when the switch circuit is powered on. Power-on of the switch circuit may include: power-on of the at least one first depletion-mode transistor and power-on of the at least one first enhancement-mode transistor.

It should be noted that the first terminal A1 of the switch circuit is electrically connected to the second terminal B1, and the first terminal A1 is further electrically connected to the fourth terminal B2. Therefore, the first terminal A1 may be referred to as a common pole (pole) of the second terminal B1 and the fourth terminal B2. The third terminal A2 of the first switch sub-circuit may be referred to as a third terminal A2 of the switch circuit. The fifth terminal A3 of the second switch sub-circuit may be referred to as a fifth terminal A3 of the switch circuit.

It can be understood that the at least one first depletion-mode transistor is turned on and the at least one first enhancement-mode transistor is turned off when the switch circuit is powered off. Therefore, it can be learned that the second terminal B1 and the third terminal A2 of the first switch sub-circuit (including the at least one first depletion-mode transistor that is connected in series) are connected, and the fourth terminal B2 and the fifth terminal A3 of the second switch sub-circuit (including the at least one first enhancement-mode transistor that is connected in series) are disconnected. Because the first terminal A1 is electrically connected to the second terminal B 1, it can be learned that, when the second terminal B1 and the third terminal A2 are connected, the first terminal A1 and the third terminal A2 are also connected. Because the first terminal A1 is electrically connected to the fourth terminal B2, it can be learned that, when the fourth terminal B2 and the fifth terminal A3 are disconnected, the first terminal A1 and the fifth terminal A3 are also disconnected.

The second switch sub-circuit may include a plurality of first enhancement-mode transistors that are connected in series. The plurality of first enhancement-mode transistors that are connected in series are all turned off when the switch circuit is powered off. In this case, the first terminal A1 and the fifth terminal A3 of the switch circuit are disconnected. Because there are the plurality of first enhancement-mode transistors that are turned off between the first terminal A1 and the fifth terminal A3 of the switch circuit, a possibility that a wireless signal is transmitted from the first terminal A1 to the fifth terminal A3 of the switch circuit is smaller. The plurality of first enhancement-mode transistors that are connected in series may implement signal isolation at the fifth terminal A3 of the switch circuit when the first terminal A1 and the fifth terminal A3 of the switch circuit are disconnected.

It can be further understood that the switch circuit may provide a path from the first terminal A1 to the third terminal A2 and a path from the first terminal A1 to the fifth terminal A3. Therefore, the switch circuit may be used in a scenario in which a plurality of first devices are connected to a same second device (for example, a scenario in which a plurality of communication modules are connected to a same antenna (Antenna, ANT), or a scenario in which a plurality of signal sources are connected to a same electronic device), the first terminal A1 is configured to be electrically connected to the second device, and the third terminal A2 and the fifth terminal A3 are configured to be electrically connected to different first devices. The first terminal A1 and the third terminal A2 of the switch circuit are connected when the switch circuit is powered off, so that the first device is connected to one of the second devices without power consumption.

For example, a scenario in which a first communication module (for example, a Wi-Fi module or a BT module) and a WUR are connected to a same antenna is used as an example. As shown in FIG. 3, the first terminal A1 of the switch circuit may be configured to be electrically connected to the antenna, the third terminal A2 of the switch circuit may be configured to be electrically connected to the WUR (which may be referred to as a first WUR), and the fifth terminal A3 of the switch circuit may be configured to be electrically connected to the first communication module. The first terminal A1 and the third terminal A2 of the switch circuit are connected and the first terminal A1 and the fifth terminal A3 of the switch circuit are disconnected when the switch circuit is powered off. Therefore, it can be learned that the first WUR is electrically connected to the antenna and the first communication module is disconnected from the antenna when the switch circuit is powered off.

It can be further understood that a depletion-mode transistor (for example, the first depletion-mode transistor) is in an on state when being powered off, and an enhancement-mode transistor (for example, the first enhancement-mode transistor) is in an off state when being powered off. Therefore, it can be learned that the second terminal B1 and the third terminal A2 of the first switch sub-circuit (including the at least one first depletion-mode transistor that is connected in series) are connected and the first terminal A1 and the third terminal A2 are also connected when the at least one first depletion-mode transistor is powered off, and the fourth terminal B2 and the fifth terminal A3 of the second switch sub-circuit (including the at least one first enhancement-mode transistor that is connected in series) are disconnected and the first terminal A1 and the fifth terminal A3 are also disconnected when the at least one first enhancement-mode transistor is powered off.

Then, the depletion-mode transistor (for example, the first depletion-mode transistor) may be in the off state by being controlled to be powered on, and the enhancement-mode transistor (for example, the first enhancement-mode transistor) may be in the on state by being controlled to be powered on. Therefore, it can be learned that the second terminal B1 and the third terminal A2 of the first switch sub-circuit (including the at least one first depletion-mode transistor that is connected in series) are disconnected when the at least one first depletion-mode transistor is powered on, and the fourth terminal B2 and the fifth terminal A3 of the second switch sub-circuit (including the at least one first enhancement-mode transistor that is connected in series) are connected when the at least one first enhancement-mode transistor is powered off. Because the first terminal A1 is electrically connected to the second terminal B1, it can be learned that, when the second terminal B1 and the third terminal A2 of the first switch sub-circuit are disconnected, the first terminal A1 and the third terminal A2 of the switch circuit are also disconnected. Because the first terminal A1 is electrically connected to the fourth terminal B2, it can be learned that, when the fourth terminal B2 and the fifth terminal A3 of the second switch sub-circuit are connected, the first terminal A1 and the fifth terminal A3 of the switch circuit are also connected.

It should be noted that FIG. 3 shows an example of an application scenario of the switch circuit provided in this embodiment of this application, and does not constitute a limitation on the application scenario of the switch circuit.

In some embodiments, when a voltage at a control terminal of the at least one first depletion-mode transistor is a first voltage value and a voltage at a control terminal of the at least one first enhancement-mode transistor is a second voltage value, the second terminal B1 and the third terminal A2 of the switch circuit are disconnected, and the fourth terminal B2 and the fifth terminal A3 of the switch circuit are connected.

The first voltage value may be any voltage value that causes the first depletion-mode transistor to be in the off state. The second voltage value may be any voltage value that causes the first enhancement-mode transistor to be in the on state.

It can be understood that the first switch sub-circuit may include a plurality of first depletion-mode transistors that are connected in series. When voltages of the plurality of first depletion-mode transistors that are connected in series are all the first voltage value, the plurality of first depletion-mode transistors are all turned off, the second terminal B1 and the third terminal A2 of the switch circuit are disconnected, and the first terminal A1 and the third terminal A2 are also disconnected. Because there are the plurality of first depletion-mode transistors that are turned off between the first terminal A1 and the third terminal A2 of the switch circuit, a possibility that a wireless signal is transmitted from the first terminal A1 to the third terminal A2 of the switch circuit is smaller. The plurality of first depletion-mode transistors that are connected in series may implement signal isolation at the third terminal A2 of the switch circuit when the first terminal A1 and the third terminal A2 of the switch circuit are disconnected.

Optionally, the first depletion-mode transistor may be a depletion-mode NMOS transistor (Negative channel Metal Oxide Semiconductor) or a depletion-mode PMOS transistor (positive channel Metal Oxide Semiconductor). The first enhancement-mode transistor may be an enhancement-mode NMOS transistor or an enhancement-mode PMOS transistor.

For example, a depletion-mode NMOS transistor is used as an example to describe a control process of the depletion-mode NMOS transistor. (a) of FIG. 4 is a diagram of a cross-sectional structure of a depletion-mode NMOS transistor. The depletion-mode NMOS transistor includes a source S1, a drain D1, and a gate G1. A current I_{D1} between the source S1 and the drain D1 is controlled by controlling a voltage value V_{gs1} of the gate G1, to control on/off of the depletion-mode NMOS transistor. As shown in (b) of FIG. 4, when the voltage value V_{gs1} of the gate G1 is equal to different values, the current I_{D1} between the source S1 and the drain D1 has different values. When V_{gs1} = 0 volts (V), I_{D1} is not equal to 0, and there is a conductive channel between the source S1 and the drain D1, which indicates that the source S1 and the drain D1 are connected (that is, the depletion-mode NMOS transistor is turned on). Therefore, it can be learned that the depletion-mode NMOS transistor is turned on when the depletion-mode NMOS transistor is powered off.

Then, when V_{gs1} = -2.5 V, I_{D1} is equal to 0, which indicates that the source S1 and the drain D1 are disconnected, that is, the depletion-mode NMOS transistor is turned off. Therefore, it can be learned that the depletion-mode NMOS transistor is turned off when a voltage at a control terminal (that is, the gate G1) of the depletion-mode NMOS transistor is -2.5 V. The first voltage value may be equal to -2.5 V.

It should be noted that different depletion-mode NMOS transistors may be turned on when being powered off. Different first voltage values may be required for turning off different depletion-mode NMOS transistors.

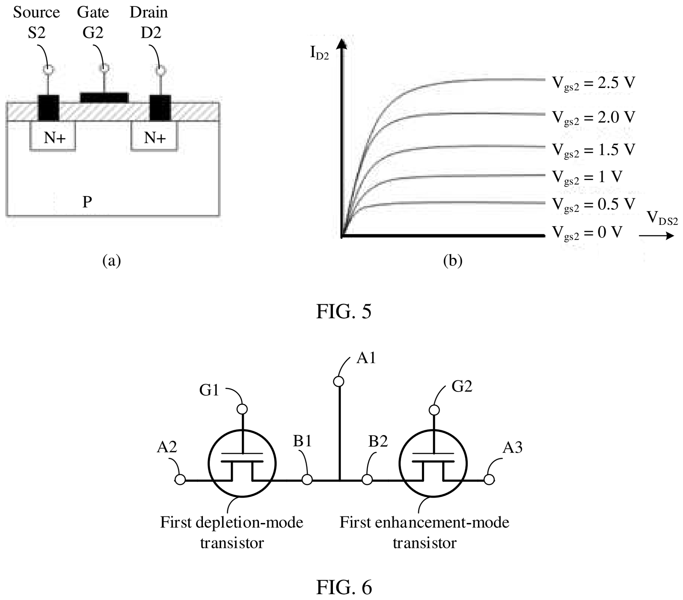

For example, an enhancement-mode NMOS transistor is used as an example to describe a control process of the enhancement-mode NMOS transistor. (a) of FIG. 5 is a diagram of a cross-sectional structure of an enhancement-mode NMOS transistor. The enhancement-mode NMOS transistor includes a source S2, a drain D2, and a gate G2. A current I_{D2} between the source S2 and the drain D2 is controlled by controlling a voltage value V_{gs2} of the gate G2, to control on/off of the enhancement-mode NMOS transistor. As shown in (b) of FIG. 5, when the voltage value V_{gs2} of the gate G2 is equal to different values, the current I_{D2} between the source S2 and the drain D2 has different values. When V_{gs2} = 0 volts (V), I_{D2} is equal to 0, which indicates that the source S2 and the drain D2 are disconnected, that is, the enhancement-mode NMOS transistor is turned off. Therefore, it can be learned that the enhancement-mode NMOS transistor is turned off when the enhancement-mode NMOS transistor is powered off.

When V_{gs2} is greater than 0 V, I_{D2} is not equal to 0, and there is a conductive channel between the source S2 and the drain D2, which indicates that the source S2 and the drain D2 are connected (that is, the enhancement-mode NMOS transistor is turned on). Therefore, it can be learned that the enhancement-mode NMOS transistor is turned on when a voltage at a control terminal (that is, the gate G2) of the enhancement-mode NMOS transistor is greater than 0 V. The second voltage value may be greater than 0 V, for example, the second voltage value is equal to 2.5 V.

It should be noted that different enhancement-mode NMOS transistors are turned off when being powered off. Different second voltage values may be required for turning on different enhancement-mode NMOS transistors.

For example, with reference to FIG. 3, as shown in FIG. 6, a circuit structure of the switch circuit provided in this embodiment of this application is described by using an example in which the first switch sub-circuit includes one first depletion-mode transistor and the second switch sub-circuit includes one first enhancement-mode transistor. As shown in FIG. 6, the first terminal A1 of the switch circuit is electrically connected to the second terminal B1 of the first switch sub-circuit, and the first terminal A1 is electrically connected to the fourth terminal B2 of the second switch sub-circuit. The second terminal B1 and the third terminal A2 of the first switch sub-circuit are two terminals of the first depletion-mode transistor included in the first switch sub-circuit. The fourth terminal B2 and the fifth terminal A3 of the second switch sub-circuit are two terminals of the first enhancement-mode transistor included in the second switch sub-circuit.

The second terminal B1 of the first switch sub-circuit is a source S1 of the first depletion-mode transistor, and the third terminal A2 of the first switch sub-circuit is a drain D1 of the first depletion-mode transistor; or the second terminal B1 of the first switch sub-circuit is a drain D1 of the first depletion-mode transistor, and the third terminal A2 of the first switch sub-circuit is a source S1 of the first depletion-mode transistor. A control terminal of the first switch sub-circuit is a gate G1 of the first depletion-mode transistor.

The fourth terminal B2 of the second switch sub-circuit is a source S2 of the first enhancement-mode transistor, and the fifth terminal A3 of the second switch sub-circuit is a drain D2 of the first enhancement-mode transistor; or the fourth terminal B2 of the second switch sub-circuit is a drain D2 of the first enhancement-mode transistor, and the fifth terminal A3 of the second switch sub-circuit is a source S2 of the first enhancement-mode transistor. A control terminal of the third enhancement-mode transistor is a gate G2 of the first enhancement-mode transistor.

It can be understood that a source and a drain of a transistor (for example, an NMOS transistor or a PMOS transistor) are symmetrical and reciprocal. Therefore, it can be learned that the second terminal B1 of the first switch sub-circuit may be the source of the transistor or may be the drain of the transistor, and correspondingly, the third terminal A2 of the first switch sub-circuit may be the drain of the transistor or may be the source of the transistor. Similarly, the fourth terminal B2 of the second switch sub-circuit may be the source or the drain of the transistor, and the fifth terminal A3 of the second switch sub-circuit is the drain and the source of the transistor.

For example, with reference to the switch circuit shown in FIG. 6, control voltages and operating states of the switch circuit are described by using an example in which the first depletion-mode transistor in the switch circuit is the depletion-mode NMOS transistor shown in FIG. 4 and the first enhancement-mode transistor in the switch circuit is the enhancement-mode NMOS transistor shown in FIG. 5, as shown in the following Table 1.

**Table 1 Control voltages and operating states of a switch circuit**

| Control voltage of the switch circuit | Operating state of the depletion-mode NMOS transistor | Operating state of the enhancement-mode NMOS transistor | Operating state of the switch circuit |
|---|---|---|---|
| V_{gs1} = 0 V, V_{gs2} = 0 V | On | Off | The first terminal A1 and the third terminal A2 are connected, and the first terminal A1 and the fifth terminal A3 are disconnected |
| V_{gs1} = -2.5 V, V_{gs2} = 2.5 V | Off | On | The first terminal A1 and the third terminal A2 are disconnected, and the first terminal A1 and the fifth terminal A3 are connected |

When the switch circuit is powered off, the voltage V_{gs1} at the control terminal of the first depletion-mode transistor is 0 V, and the voltage V_{gs2} at the control terminal of the first enhancement-mode transistor is 0 V. When V_{gs1} = 0 V, the first depletion-mode transistor is turned on, the second terminal B1 and the third terminal A2 of the switch circuit are connected, and the first terminal A1 and the third terminal A2 are also connected. When V_{gs2} = 0 V, the first enhancement-mode transistor is turned off, the fourth terminal B2 and the fifth terminal A3 of the switch circuit are disconnected, and the first terminal A1 and the fifth terminal A3 are also disconnected.

When the switch circuit is powered on, the voltage V_{gs1} at the control terminal of the first depletion-mode transistor is -2.5 V, and the voltage V_{gs2} at the control terminal of the first enhancement-mode transistor is 2.5 V. When V_{gs1} = -2.5 V, the first depletion-mode transistor is turned off, the second terminal B1 and the third terminal A2 of the switch circuit are disconnected, and the first terminal A1 and the third terminal A2 are also disconnected. When V_{gs2} = 2.5 V, the first enhancement-mode transistor is turned on, the fourth terminal B2 and the fifth terminal A3 of the switch circuit are connected, and the first terminal A1 and the fifth terminal A3 are also connected. The first voltage value may be -2.5 V and the second voltage value may be 2.5 V.

It should be noted that Table 1 exemplarily describes a value of the first voltage value that controls the depletion-mode NMOS transistor to be turned off, and the first voltage value that controls the depletion-mode NMOS transistor to be turned off may alternatively be another value. Table 1 exemplarily describes a value of the second voltage value that controls the enhancement-mode NMOS transistor to be turned on, and the second voltage value that controls the enhancement-mode NMOS transistor to be turned on may alternatively be another value.

For example, with reference to the switch circuit shown in FIG. 6, control voltages and operating states of the switch circuit are described by using an example in which the first depletion-mode transistor in the switch circuit is a depletion-mode PMOS transistor and the first enhancement-mode transistor in the switch circuit is an enhancement-mode PMOS transistor, as shown in the following Table 2.

**Table 2 Control voltages and operating states of another switch circuit**

| Control voltage of the switch circuit | Operating state of the depletion-mode PMOS transistor | Operating state of the enhancement-mode PMOS transistor | Operating state of the switch circuit |
|---|---|---|---|
| V_{gs1} = 0 V, V_{gs2} = 0 V | On | Off | The first terminal A1 and the third terminal A2 are connected, and the first terminal A1 and the fifth terminal A3 are disconnected |
| V_{gs1} = 2.5 V, V_{gs2} = -2.5 V | Off | On | The first terminal A1 and the third terminal A2 are disconnected, and the first terminal A1 and the fifth terminal A3 are connected |

When the switch circuit is powered off, the voltage V_{gs1} at the control terminal of the first depletion-mode transistor is 0 V, and the voltage V_{gs2} at the control terminal of the first enhancement-mode transistor is 0 V. When V_{gs1} = 0 V, the first depletion-mode transistor is turned on, and the first terminal A1 and the third terminal A2 of the switch circuit are connected. When V_{gs2} = 0 V, the first enhancement-mode transistor is turned off, and the first terminal A1 and the fifth terminal A3 of the switch circuit are disconnected.

When the switch circuit is powered on, the voltage V_{gs1} at the control terminal of the first depletion-mode transistor is 2.5 V, and the voltage V_{gs2} at the control terminal of the first enhancement-mode transistor is -2.5 V. When V_{gs1} = 2.5 V, the first depletion-mode transistor is turned off, and the first terminal A1 and the third terminal A2 of the switch circuit are disconnected. When V_{gs2} = -2.5 V, the first enhancement-mode transistor is turned on, and the first terminal A1 and the fifth terminal A3 of the switch circuit are connected. The first voltage value may be 2.5 V and the second voltage value may be -2.5 V.

It should be noted that Table 2 exemplarily describes a value of the first voltage value that controls the depletion-mode PMOS transistor to be turned off, and the first voltage value that controls the depletion-mode PMOS transistor to be turned off may alternatively be another value. Table 2 exemplarily describes a value of the second voltage value that controls the enhancement-mode PMOS transistor to be turned on, and the second voltage value that controls the enhancement-mode PMOS transistor to be turned on may alternatively be another value.

It should be further noted that, in addition to the first switch sub-circuit and the second switch sub-circuit shown in FIG. 6, the first switch sub-circuit may alternatively include a plurality of first depletion-mode transistors that are connected in series, and the second switch sub-circuit may alternatively include a plurality of first enhancement-mode transistors that are connected in series. For details about the plurality of first depletion-mode transistors, refer to the descriptions of the first depletion-mode transistor in the foregoing embodiment; and for details about the plurality of first enhancement-mode transistors, refer to the descriptions of the first enhancement-mode transistor in the foregoing embodiment. Details are not described herein in this embodiment of this application again.

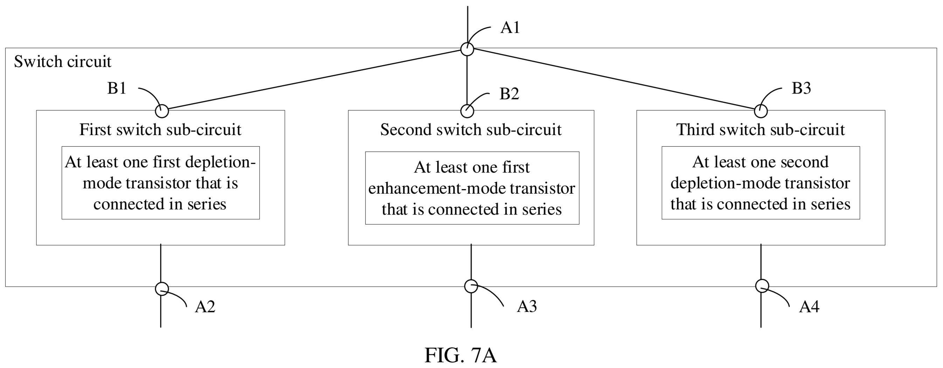

In some embodiments, as shown in FIG. 7A, in addition to the first switch sub-circuit and the second switch sub-circuit, the switch circuit may further include a third switch sub-circuit. The third switch sub-circuit is connected in parallel to the first switch sub-circuit and the second switch sub-circuit. The third switch sub-circuit includes a sixth terminal B3 and a seventh terminal A4. In addition to being electrically connected to the second terminal B1 of the first switch sub-circuit and the fourth terminal B2 of the second switch sub-circuit, the first terminal A1 of the switch circuit is further electrically connected to the sixth terminal B3 of the third switch sub-circuit. The third switch sub-circuit may include at least one second depletion-mode transistor that is connected in series. The sixth terminal B3 and the seventh terminal A4 of the third switch sub-circuit may be two terminals of the at least one second depletion-mode transistor that is connected in series.

When the switch circuit is powered off, the second terminal B1 and the third terminal A2 are connected, the fourth terminal B2 and the fifth terminal A3 are disconnected, and the sixth terminal B3 and the seventh terminal A4 are connected. When a voltage at a control terminal of the at least one second depletion-mode transistor is the first voltage value, the sixth terminal B3 and the seventh terminal A4 are disconnected.

It should be noted that the first terminal A1 of the switch circuit is electrically connected to the second terminal B1, the first terminal A1 is electrically connected to the fourth terminal B2, and the first terminal A1 is electrically connected to the sixth terminal B3. Therefore, the first terminal A1 of the switch circuit may be referred to as a common pole of the second terminal B1, the fourth terminal B2, and the sixth terminal B3. The seventh terminal A4 of the third switch sub-circuit may be referred to as a seventh terminal A4 of the switch circuit. In addition, because the first terminal A1 of the switch circuit is electrically connected to the sixth terminal B3, it can be learned that, when the sixth terminal B3 and the seventh terminal A4 are connected, the first terminal A1 and the seventh terminal A4 are also connected, and when the sixth terminal B3 and the seventh terminal A4 are disconnected, the first terminal A1 and the seventh terminal A4 are also disconnected.

It should be further noted that, for details about the third switch sub-circuit, refer to the descriptions of the first switch sub-circuit in the foregoing embodiment, and for details about the second depletion-mode transistor, refer to the foregoing descriptions of the first depletion-mode transistor. Details are not described herein in this embodiment of this application again.

It can be understood that both the first switch sub-circuit and the third switch sub-circuit in the switch circuit are turned on when being powered off, and the first terminal and the third terminal are connected when the first switch sub-circuit is turned on and the first terminal and the seventh terminal are connected when the second switch sub-circuit is turned on. Therefore, it can be learned that a plurality of conductive paths (including a path from the second terminal to the third terminal and a path from the first terminal to the seventh terminal) may be provided when the switch circuit is powered off, that is, a plurality of conductive paths may be provided without the switch circuit consuming any power. The switch circuit may be used, when being powered off, in a scenario in which a plurality of conductive paths are required, for example, a scenario in which a plurality of WURs with different operating frequency bands perform wireless signal listening.

For example, in the scenario in which a plurality of WURs with different operating frequency bands perform wireless signal listening, the first terminal A1 of the switch circuit may be configured to be electrically connected to an antenna, the third terminal A2 of the switch circuit may be configured to be electrically connected to a first WUR, the fifth terminal A3 of the switch circuit may be configured to be electrically connected to a first communication module, and the seventh terminal A4 of the switch circuit may be configured to be electrically connected to a second WUR. Operating frequency bands of the first WUR and the second WUR are different, for example, the operating frequency band of the first WUR is 1800 hertz (MHz), and the operating frequency band of the second WUR is 2400 MHz. Therefore, when the switch circuit is powered off, both the at least one first depletion-mode transistor and the at least one second depletion-mode transistor are turned on, and the at least one first enhancement-mode transistor is turned off. When both the at least one first depletion-mode transistor and the at least one second depletion-mode transistor are turned on, the first terminal A1 and the third terminal A2 of the switch circuit are connected, and the first terminal A1 and the seventh terminal A4 of the switch circuit are also connected. In this case, both the first WUR and the second WUR are connected to a same antenna, and both the first WUR and the second WUR may simultaneously perform wireless signal listening.

The third terminal A2 of the switch circuit may be connected to the first WUR through a first filter, and the first filter is configured to transmit, to the first WUR, a wireless signal (for example, a wireless signal of 1800 MHz) that meets the operating frequency band of the first WUR. The seventh terminal A4 of the switch circuit may be connected to the second WUR through a second filter, and the second filter is configured to transmit, to the second WUR, a wireless signal (for example, a wireless signal of 2400 MHz) that meets the operating frequency band of the second WUR.

It should be noted that the switch circuit may include one third switch sub-circuit, or may include a plurality of third switch sub-circuits. For details about each of the plurality of third switch sub-circuits (including a connection manner and on/off cases), refer to the descriptions of the third switch sub-circuit in the foregoing embodiment. Details are not described herein in this embodiment of this application again.

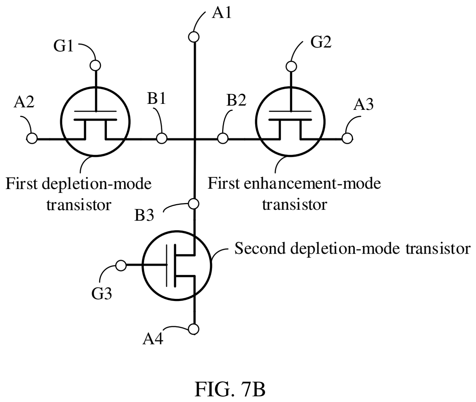

For example, with reference to the switch circuit shown in FIG. 7A, as shown in FIG. 7B, a circuit structure of the switch circuit provided in this embodiment of this application is described by using an example in which the first switch sub-circuit includes one first depletion-mode transistor, the second switch sub-circuit includes one first enhancement-mode transistor, and the third switch sub-circuit includes one second depletion-mode transistor. As shown in FIG. 7B, the first terminal A1 of the switch circuit is electrically connected to the second terminal B1 of the first switch sub-circuit, the fourth terminal B2 of the second switch sub-circuit, and the sixth terminal B3 of the third switch sub-circuit. The sixth terminal B3 and the seventh terminal A4 of the third switch sub-circuit are two terminals of the second depletion-mode transistor included in the third switch sub-circuit.

The sixth terminal B3 of the third switch sub-circuit is a source S3 of the second depletion-mode transistor, and the seventh terminal A4 of the third switch sub-circuit is a drain D3 of the second depletion-mode transistor; or the sixth terminal B3 of the third switch sub-circuit is a drain D3 of the first depletion-mode transistor, and the seventh terminal A4 of the third switch sub-circuit is a source S3 of the second depletion-mode transistor. The control terminal of the second depletion-mode transistor is a gate G3 of the second depletion-mode transistor.

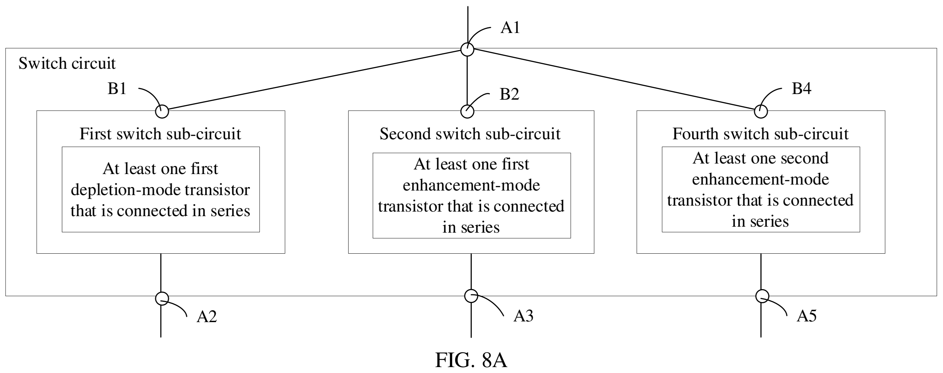

In some embodiments, as shown in FIG. 8A, in addition to the first switch sub-circuit and the second switch sub-circuit, the switch circuit may further include a fourth switch sub-circuit. The fourth switch sub-circuit is connected in parallel to the first switch sub-circuit and the second switch sub-circuit. The fourth switch sub-circuit includes an eighth terminal B4 and a ninth terminal A5. In addition to being electrically connected to the second terminal B1 of the first switch sub-circuit and the fourth terminal B2 of the second switch sub-circuit, the first terminal A1 of the switch circuit is further electrically connected to the eighth terminal B4 of the fourth switch sub-circuit. The fourth switch sub-circuit may include at least one second enhancement-mode transistor that is connected in series. The eighth terminal B4 and the ninth terminal A5 of the fourth switch sub-circuit may be two terminals of the at least one second enhancement-mode transistor that is connected in series.

When the switch circuit is powered off, the second terminal B1 and the third terminal A2 are connected, the fourth terminal B2 and the fifth terminal A3 are disconnected, and the eighth terminal B4 and the ninth terminal A5 are disconnected. When a voltage at a control terminal of the at least one second enhancement-mode transistor is the second voltage value, the eighth terminal B4 and the ninth terminal A5 are connected.

It should be noted that the first terminal A1 of the switch circuit is electrically connected to the second terminal B1, the first terminal A1 is electrically connected to the fourth terminal B2, and the first terminal A1 is electrically connected to the eighth terminal B4. Therefore, the first terminal A1 of the switch circuit may be referred to as a common pole of the second terminal B1, the fourth terminal B2, and the eighth terminal B4. The ninth terminal A5 of the fourth switch sub-circuit may be referred to as a ninth terminal A5 of the switch circuit. In addition, because the first terminal A1 of the switch circuit is electrically connected to the eighth terminal B4, it can be learned that, when the eighth terminal B4 and the ninth terminal A5 are connected, the first terminal A1 and the ninth terminal A5 are also connected, and when the eighth terminal B4 and the ninth terminal A5 are disconnected, the first terminal A1 and the ninth terminal A5 are also disconnected.

It should be further noted that, for details about the fourth switch sub-circuit, refer to the descriptions of the second switch sub-circuit in the foregoing embodiment, and for details about the second enhancement-mode transistor, refer to the descriptions of the first enhancement-mode transistor in the foregoing embodiment. Details are not described herein in this embodiment of this application again.

In addition, the switch circuit may include one fourth switch sub-circuit, or may include a plurality of fourth switch sub-circuits. For details about each of the plurality of fourth switch sub-circuits (including a connection manner and on/off cases), refer to the descriptions of the fourth switch sub-circuit in the foregoing embodiment. Details are not described herein in this embodiment of this application again.

For example, the first terminal A1 of the switch circuit may be configured to be electrically connected to an antenna, the third terminal A2 of the switch circuit may be configured to be electrically connected to a WUR, the fifth terminal A3 of the switch circuit may be configured to be electrically connected to a first communication module, and the ninth terminal A5 of the switch circuit may be configured to be electrically connected to a second communication module (for example, a Wi-Fi module or a BT module). Therefore, when the voltage at the control terminal of the at least one first depletion-mode transistor is the first voltage value, the voltage at the control terminal of the at least one first enhancement-mode transistor is the second voltage value, and the voltage at the control terminal of the at least one second enhancement-mode transistor is a third voltage value 0 V, the first terminal A1 and the third terminal A2 of the switch circuit are disconnected, the first terminal A1 and the fifth terminal A3 of the switch circuit are connected, and the first terminal A1 of the switch circuit and the ninth terminal A5 of the switch circuit are disconnected. In this case, the first communication module is connected to the antenna to perform wireless signal receiving/transmitting, and both the WUR and the second communication module are disconnected from the antenna. The third voltage value may be a voltage value used to control an enhancement-mode transistor (for example, the second enhancement-mode transistor) to be turned off. The third voltage value may be a voltage value less than or equal to 0 V, for example, 0 V or -2.5 V. Compared with 0 V, -2.5 V can be used to more effectively turn off the enhancement-mode transistor.

Optionally, when the voltage at the control terminal of the at least one first depletion-mode transistor is the first voltage value, the voltage at the control terminal of the at least one first enhancement-mode transistor is the third voltage value, and the voltage at the control terminal of the at least one second enhancement-mode transistor is the second voltage value, the first terminal A1 and the third terminal A2 of the switch circuit are disconnected, the first terminal A1 and the fifth terminal A3 of the switch circuit are disconnected, and the first terminal A1 and the ninth terminal A5 of the switch circuit are connected. In this case, the second communication module is connected to the antenna to perform wireless signal receiving/transmitting, and both the WUR and the first communication module are disconnected from the antenna.

It can be understood that, in addition to the second switch sub-circuit including an enhancement-mode transistor, the switch circuit may further include the fourth switch sub-circuit including an enhancement-mode transistor. A path in the second switch sub-circuit and the fourth switch sub-circuit may be conductive by controlling the switch circuit to be powered on, so that the first communication module connected to the second switch sub-circuit is connected to the antenna, or the second communication module connected to the fourth switch sub-circuit is connected to the antenna.

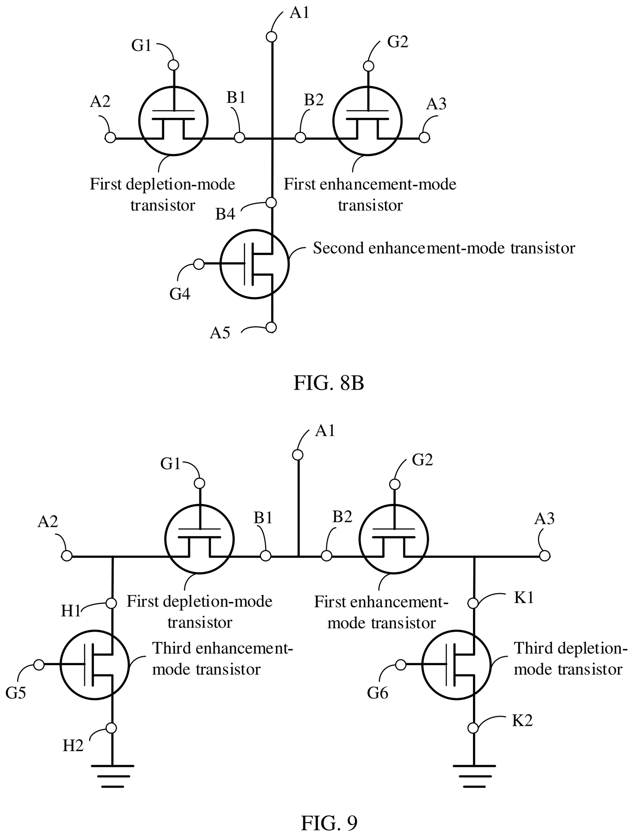

For example, with reference to the switch circuit shown in FIG. 8A, as shown in FIG. 8B, a circuit structure of the switch circuit provided in this embodiment of this application is described by using an example in which the first switch sub-circuit includes one first depletion-mode transistor, the second switch sub-circuit includes one first enhancement-mode transistor, and the fourth switch sub-circuit includes one second enhancement-mode transistor. As shown in FIG. 8B, the first terminal A1 of the switch circuit is electrically connected to the second terminal B1 of the first switch sub-circuit, the first terminal A1 is electrically connected to the fourth terminal B2 of the second switch sub-circuit, and the first terminal A1 is electrically connected to the eighth terminal B4 of the fourth switch sub-circuit. The eighth terminal B4 and the ninth terminal A5 of the fourth switch sub-circuit are two terminals of the second enhancement-mode transistor included in the fourth switch sub-circuit.

The eighth terminal B4 of the fourth switch sub-circuit is a source S4 of the second enhancement-mode transistor, and the ninth terminal A5 of the fourth switch sub-circuit is a drain D4 of the second enhancement-mode transistor; or the eighth terminal B4 of the fourth switch sub-circuit is a drain D4 of the first depletion-mode transistor, and the ninth terminal A5 of the fourth switch sub-circuit is a source S4 of the second enhancement-mode transistor. The control terminal of the fourth switch sub-circuit is a gate G4 of the second enhancement-mode transistor.

In some embodiments, in addition to the at least one first depletion-mode transistor that is connected in series, the first switch sub-circuit may further include a first branch circuit. The first branch circuit is a branch circuit connected in parallel to the first switch sub-circuit, and the first branch circuit includes at least one third enhancement-mode transistor that is connected in series. The first branch circuit includes a tenth terminal H1 and an eleventh terminal H2, and the tenth terminal H1 and the eleventh terminal H2 are two terminals of the first branch circuit. The tenth terminal H1 of the first branch circuit is electrically connected to the first switch sub-circuit, and the eleventh terminal H2 of the first branch circuit is grounded. The tenth terminal H1 of the first branch circuit may be electrically connected to a source or a drain of any one of the at least one first depletion-mode transistor.

When the switch circuit is powered off, a voltage at a control terminal of the at least one third enhancement-mode transistor is 0 V, the at least one third enhancement-mode transistor is turned off, and the tenth terminal H1 and the eleventh terminal H2 of the first branch circuit are disconnected. When the voltage at the control terminal of the at least one third enhancement-mode transistor is the second voltage value, the tenth terminal H1 and the eleventh terminal H2 of the first branch circuit are connected, and the tenth terminal H1 of the first branch circuit is grounded.

It should be noted that, for details about the third enhancement-mode transistor, refer to the descriptions of the first enhancement-mode transistor in the foregoing embodiment. Details are not described herein in this embodiment of this application again.

It should be further noted that the first switch sub-circuit may include one first branch circuit, or may include a plurality of first branch circuits. For details about each of the plurality of first branch circuits (including a connection manner and on/off cases), refer to the descriptions of the first branch circuit in the foregoing embodiment. Details are not described herein in this embodiment of this application again.

It can be understood that, when the voltage at the control terminal of the at least one first depletion-mode transistor is the first voltage value, and both the voltage at the control terminal of the at least one first enhancement-mode transistor and the voltage at the control terminal of the at least one third enhancement-mode transistor are the second voltage value, the at least one first depletion-mode transistor is turned off, the at least one first enhancement-mode transistor is turned on, and the at least one third enhancement-mode transistor is turned on. If the at least one first depletion-mode transistor is turned off, the second terminal B1 and the third terminal A2 of the first switch sub-circuit (including the at least one first depletion-mode transistor that is connected in series) are disconnected, and the first terminal A1 and the third terminal A2 of the switch circuit are also disconnected. If the at least one first enhancement-mode transistor is turned on, the fourth terminal B2 and the fifth terminal A3 of the second switch sub-circuit (including the at least one first enhancement-mode transistor that is connected in series) are connected, and the first terminal A1 and the fifth terminal A3 of the switch circuit are also connected. If the at least one third enhancement-mode transistor is turned on, the tenth terminal H1 and the eleventh terminal H2 of the first branch circuit are also connected, and the tenth terminal H1 of the first branch circuit is grounded.

Therefore, if some wireless signals are still leaked and transmitted from the second terminal B1 to the third terminal A2 of the first switch sub-circuit when the second terminal B1 and the third terminal A2 of the first switch sub-circuit are disconnected, because the first switch sub-circuit is connected to the grounded first branch circuit, the leaked wireless signals may be transmitted to the ground through the grounded first branch circuit, instead of being transmitted from the second terminal B1 to the third terminal A2 of the first switch sub-circuit. That is, the first branch circuit may enhance signal isolation at the third terminal A2 of the first switch sub-circuit when the first switch sub-circuit is turned off.

For example, with reference to the switch circuit shown in FIG. 6, as shown in FIG. 9, a circuit structure of the switch circuit provided in this embodiment of this application is described by using an example in which the first switch sub-circuit includes one first depletion-mode transistor, the second switch sub-circuit includes one first enhancement-mode transistor, and the first branch circuit includes one third enhancement-mode transistor. As shown in FIG. 9, the tenth terminal H1 of the first branch circuit is electrically connected to the third terminal A2 of the first switch sub-circuit, and the eleventh terminal H2 of the first branch circuit is grounded.

The tenth terminal H1 of the first branch circuit is a source S5 of the third enhancement-mode transistor, and the eleventh terminal H2 of the first branch circuit is a drain D5 of the third enhancement-mode transistor; or the tenth terminal H1 of the first branch circuit is a drain D5 of the third enhancement-mode transistor, and the tenth terminal H1 of the first branch circuit is a source S5 of the third enhancement-mode transistor. The control terminal of the third enhancement-mode transistor is a gate G5 of the third enhancement-mode transistor.

In some embodiments, in addition to the at least one first enhancement-mode transistor that is connected in series, the second switch sub-circuit may further include a second branch circuit. The second branch circuit is a branch circuit connected in parallel to the second switch sub-circuit, and the second branch circuit includes at least one third depletion-mode transistor that is connected in series. The second branch circuit includes a twelfth terminal K1 and a thirteenth terminal K2, and the twelfth terminal K1 and the thirteenth terminal K2 are two terminals of the second branch circuit. The twelfth terminal K1 of the second branch circuit is electrically connected to the second switch sub-circuit, and the thirteenth terminal K2 of the second branch circuit is grounded. The twelfth terminal K1 of the second branch circuit may be electrically connected to a source or a drain of any one of the at least one first enhancement-mode transistor.

When the switch circuit is powered off, a voltage at a control terminal of the at least one third depletion-mode transistor is 0 V, the at least one third depletion-mode transistor is turned on, and the twelfth terminal K1 and the thirteenth terminal K2 of the second branch circuit are connected. When the voltage at the control terminal of the at least one third depletion-mode transistor is the first voltage value, the twelfth terminal K1 and the thirteenth terminal K2 of the second branch circuit are disconnected.

It should be noted that, for details about the third depletion-mode transistor, refer to the descriptions of the first depletion-mode transistor in the foregoing embodiment. Details are not described herein in this embodiment of this application again.

It should be further noted that the second switch sub-circuit may include one second branch circuit, or may include a plurality of second branch circuits. For details about each of the plurality of second branch circuits (including a connection manner and on/off cases), refer to the descriptions of the second branch circuit in the foregoing embodiment. Details are not described herein in this embodiment of this application again.

It can be understood that, when the switch circuit is powered off, the at least one first depletion-mode transistor is turned on, the at least one first enhancement-mode transistor is turned off, and the at least one third depletion-mode transistor is turned on. If the at least one first depletion-mode transistor is turned on, the second terminal B1 and the third terminal A2 of the first switch sub-circuit (including the at least one first depletion-mode transistor that is connected in series) are connected, and the first terminal A1 and the third terminal A2 of the switch circuit are also connected. If the at least one first enhancement-mode transistor is turned off, the fourth terminal B2 and the fifth terminal A3 of the second switch sub-circuit (including the at least one first enhancement-mode transistor that is connected in series) are disconnected, and the first terminal A1 and the fifth terminal A3 of the switch circuit are also disconnected. If the at least one third depletion-mode transistor is turned on, the twelfth terminal K1 and the thirteenth terminal K2 of the second branch circuit are also connected, and the twelfth terminal K1 of the second branch circuit is grounded.

Therefore, if some wireless signals are still leaked and transmitted from the fourth terminal B2 to the fifth terminal A3 of the second switch sub-circuit when the fourth terminal B2 and the fifth terminal A3 of the second switch sub-circuit are disconnected, because the second switch sub-circuit is connected to the grounded second branch circuit, the leaked wireless signals may be transmitted to the ground through the grounded second branch circuit, instead of being transmitted from the fourth terminal B2 to the fifth terminal A3 of the second switch sub-circuit. That is, the second branch circuit may enhance signal isolation at the fifth terminal A3 of the second switch sub-circuit when the second switch sub-circuit is turned off.

For example, with reference to the switch circuit shown in FIG. 6, as shown in FIG. 9, a circuit structure of the switch circuit provided in this embodiment of this application is described by using an example in which the first switch sub-circuit includes one first depletion-mode transistor, the second switch sub-circuit includes one first depletion-mode transistor, the first branch circuit includes one third enhancement-mode transistor, and the second branch circuit includes one third depletion-mode transistor. As shown in FIG. 9, the twelfth terminal K1 of the second branch circuit is electrically connected to the fifth terminal A3 of the second switch sub-circuit, and the thirteenth terminal K2 of the second branch circuit is grounded.

The twelfth terminal K1 of the second branch circuit is a source S6 of the third depletion-mode transistor, and the thirteenth terminal K2 of the second branch circuit is a drain D6 of the third depletion-mode transistor; or the twelfth terminal K1 of the second branch circuit is a drain D6 of the third depletion-mode transistor, and the twelfth terminal K1 of the second branch circuit is a source S6 of the third depletion-mode transistor. The control terminal of the third depletion-mode transistor is a gate G6 of the third depletion-mode transistor.

For example, with reference to the switch circuit shown in FIG. 9, control voltages and operating states of the switch circuit are described by using an example in which the first depletion-mode transistor and the third depletion-mode transistor are the depletion-mode NMOS transistor shown in FIG. 4, and the first enhancement-mode transistor and the third enhancement-mode transistor are the enhancement-mode NMOS transistor shown in FIG. 5, as shown in the following Table 3.

**Table 3 Control voltages and operating states of still another switch circuit**

| Control voltage of the switch circuit | Operating state of the depletion-mode NMOS transistor | Operating state of the enhancement-mode NMOS transistor | Operating state of the switch circuit |
|---|---|---|---|
| V_{gs1} = 0 V, V_{gs2} = 0 V, V_{gs3} = 0 V, V_{gs4} = 0 V, | On | Off | The first terminal A1 and the third terminal A2 are connected, the first terminal A1 and the fifth terminal A3 are disconnected, the tenth terminal H1 and the eleventh terminal H2 of the first branch circuit are disconnected, and the twelfth terminal K1 of the second branch circuit is grounded |
| V_{gs1} = -2.5 V, V_{gs2} = 2.5 V, V_{gs3} = -2.5 V, V_{gs4} = 2.5 V | Off | On | The first terminal A1 and the third terminal A2 are disconnected, the first terminal A1 and the fifth terminal A3 are connected, the tenth terminal H1 of the first branch circuit is grounded, and the twelfth terminal K1 and the thirteenth terminal K2 of the second branch circuit are disconnected |

When the switch circuit is powered off, the voltage V_{gs1} at the control terminal of the first depletion-mode transistor is 0 V, the voltage V_{gs2} at the control terminal of the first enhancement-mode transistor is 0 V, a voltage V_{gs3} at the control terminal of the third depletion-mode transistor is 0 V, and a voltage V_{gs4} at the control terminal of the third enhancement-mode transistor is 0 V. When V_{gs1} = 0 V, the first depletion-mode transistor is turned on, and the first terminal A1 and the third terminal A2 of the switch circuit are connected. When V_{gs2} = 0 V, the first enhancement-mode transistor is turned off, and the first terminal A1 and the fifth terminal A3 of the switch circuit are disconnected. When V_{gs3} = 0 V, the third depletion-mode transistor is turned on, the twelfth terminal K1 and the thirteenth terminal K2 of the second branch circuit in the switch circuit are connected, and the twelfth terminal K1 of the second branch circuit is grounded. When V_{gs4} = 0 V, the third enhancement-mode transistor is turned off, and the tenth terminal H1 and the eleventh terminal H2 of the first branch circuit in the switch circuit are disconnected.

When the switch circuit is powered on, the voltage V_{gs1} at the control terminal of the first depletion-mode transistor is -2.5 V, the voltage V_{gs2} at the control terminal of the first enhancement-mode transistor is 2.5 V, the voltage V_{gs3} at the control terminal of the third depletion-mode transistor is -2.5 V, and the voltage V_{gs4} at the control terminal of the third enhancement-mode transistor is 2.5 V. When V_{gs1} = -2.5 V, the first depletion-mode transistor is turned off, and the first terminal A1 and the third terminal A2 of the switch circuit are disconnected. When V_{gs2} = 2.5 V, the first enhancement-mode transistor is turned on, and the first terminal A1 and the fifth terminal A3 of the switch circuit are connected. When V_{gs3} = -2.5 V, the third depletion-mode transistor is turned off, and the twelfth terminal K1 and the thirteenth terminal K2 of the second branch circuit in the switch circuit are disconnected. When V_{gs4} = 2.5 V, the third enhancement-mode transistor is turned on, the tenth terminal H1 and the eleventh terminal H2 of the first branch circuit in the switch circuit are connected, and the tenth terminal H1 of the first branch circuit is grounded.

In some embodiments, the third switch sub-circuit in the switch circuit may include a third branch circuit. The fourth switch sub-circuit in the switch circuit may include a fourth branch circuit.

It should be noted that, for details about the third branch circuit in the third switch sub-circuit (including a connection manner and on/off cases), refer to the descriptions of the first branch circuit in the first switch sub-circuit in the foregoing embodiment, and for details about the fourth branch circuit in the fourth switch sub-circuit, refer to the descriptions of the fourth branch circuit in the second switch sub-circuit in the foregoing embodiment. Details are not described herein in this embodiment of this application again.

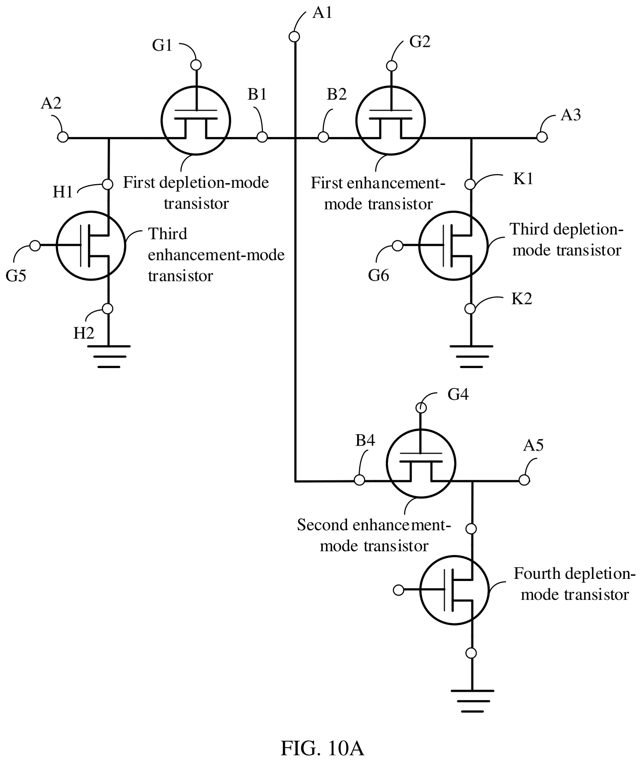

For example, with reference to the switch circuit shown in FIG. 9, as shown in FIG. 10A, the switch circuit may further include a fourth switch sub-circuit, and the fourth switch sub-circuit includes a second enhancement-mode transistor and a fourth branch circuit. The fourth branch circuit may include a fourth depletion-mode transistor. One terminal of the fourth depletion-mode transistor is electrically connected to one terminal of the second enhancement-mode transistor, and the other terminal of the fourth depletion-mode transistor is grounded.

When the switch circuit is powered off, the first depletion-mode transistor, the third depletion-mode transistor, and the fourth depletion-mode transistor are all turned on, and the first enhancement-mode transistor, the second enhancement-mode transistor, and the third enhancement-mode transistor are all turned off.

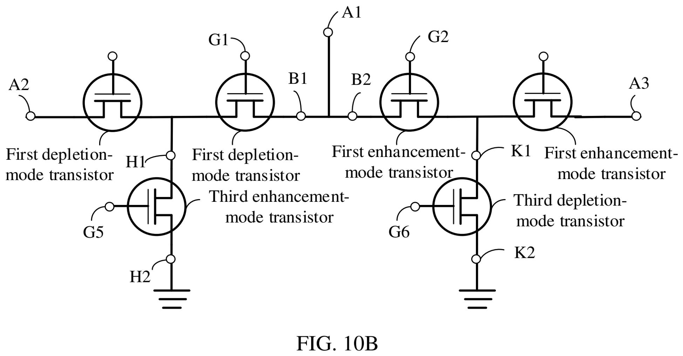

For example, with reference to the switch circuit shown in FIG. 9, and a switch circuit shown in FIG. 10B, the switch circuit may include a first switch sub-circuit and a second switch sub-circuit that are connected in parallel. The first switch sub-circuit includes two first depletion-mode transistors that are connected in series and a first branch circuit. The second switch sub-circuit includes two first enhancement-mode transistors that are connected in series and a second branch circuit. The first branch circuit includes a third enhancement-mode transistor. One terminal of the third enhancement-mode transistor is electrically connected to one terminal of each of the two first depletion-mode transistors, and the other terminal of the third enhancement-mode transistor is grounded. The second branch circuit includes a third depletion-mode transistor. One terminal of the third depletion-mode transistor is electrically connected to one terminal of each of the two first enhancement-mode transistors, and the other terminal of the third depletion-mode transistor is grounded.

When the switch circuit is powered off, the two first depletion-mode transistors and the third depletion-mode transistor are all turned on, and the two first enhancement-mode transistors and the third enhancement-mode transistor are all turned off.

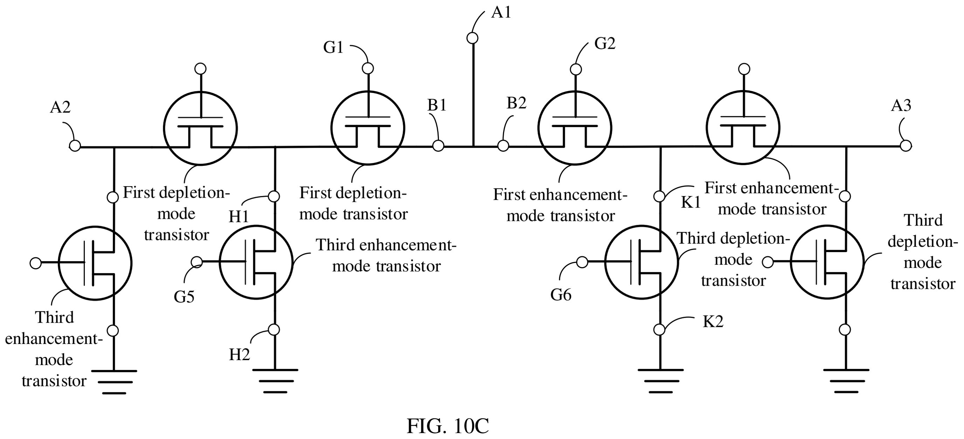

For example, with reference to the switch circuit shown in FIG. 9, and a switch circuit shown in FIG. 10C, the switch circuit may include a first switch sub-circuit and a second switch sub-circuit that are connected in parallel. The first switch sub-circuit includes two first depletion-mode transistors that are connected in series and two first branch circuits. The second switch sub-circuit includes two first enhancement-mode transistors that are connected in series and two second branch circuits. Each first branch circuit includes a third enhancement-mode transistor. One terminal of the third enhancement-mode transistor in one of the first branch circuits is electrically connected to one terminal of each of the two first depletion-mode transistors that are connected in series, and the other terminal of the third enhancement-mode transistor in the first branch circuit is grounded. One terminal of the third enhancement-mode transistor in the other first branch circuit is electrically connected to one terminal of one of the first depletion-mode transistors, and the other terminal of the third enhancement-mode transistor in the other first branch circuit is grounded. Each second branch circuit includes a third depletion-mode transistor. One terminal of the third depletion-mode transistor in one of the second branch circuits is electrically connected to one terminal of each of the two first enhancement-mode transistors that are connected in series, and the other terminal of the third depletion-mode transistor in the second branch circuit is grounded. One terminal of the third depletion-mode transistor in the other second branch circuit is electrically connected to one terminal of one of the first enhancement-mode transistors, and the other terminal of the third depletion-mode transistor in the other second branch circuit is grounded.

When the switch circuit is powered off, the two first depletion-mode transistors and the third depletion-mode transistors in the two first branch circuits are all turned on, and the two first enhancement-mode transistors and the third enhancement-mode transistors in the two second branch circuits are all turned off.

It should be noted that, in the following embodiment, a scenario in which a plurality of communication modules are connected to a same antenna is used as an example to describe a communication device applied in the scenario.

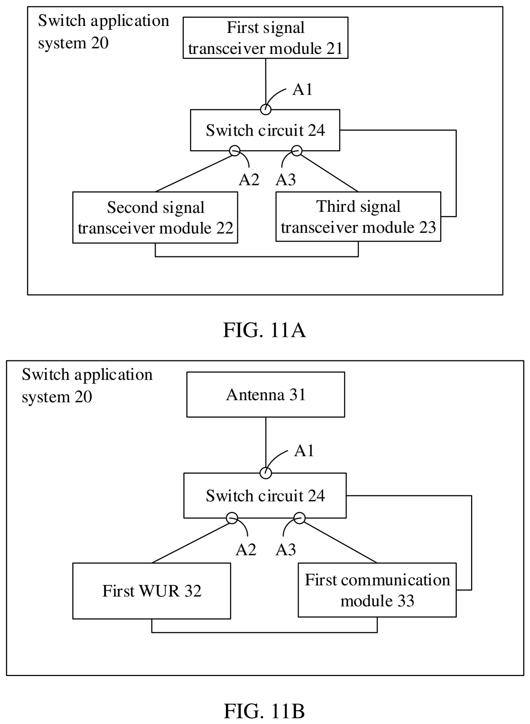

FIG. 11A shows a switch application system according to an embodiment of this application. A switch application system 20 includes a first signal transceiver module 21, a second signal transceiver module 22, a third signal transceiver module 23, and a switch circuit 24. The switch circuit 24 includes a first terminal A1. The switch circuit 24 includes a first switch sub-circuit 24 and a second switch sub-circuit 24 that are connected in parallel, the first switch sub-circuit 24 includes at least one first depletion-mode transistor that is connected in series, and the second switch sub-circuit 24 includes at least one first enhancement-mode transistor that is connected in series. The first switch sub-circuit 24 includes a second terminal B1 and a third terminal A2, and the second switch sub-circuit 24 includes a fourth terminal B2 and a fifth terminal A3. The first terminal A1 is electrically connected to the second terminal B1, and the first terminal A1 is electrically connected to the fourth terminal B2. The first terminal A1 is electrically connected to the first signal transceiver module 21, the third terminal A2 is electrically connected to the second signal transceiver module 22, and the fifth terminal A3 is electrically connected to the third signal transceiver module 23. The switch circuit 24 may be the switch circuit shown in FIG. 3 or FIG. 6.

The second signal transceiver module 22 is configured to perform signal transmission with the first signal transceiver module 21 through the switch circuit 24 when the switch circuit 24 is powered off. The third signal transceiver module 23 is configured to perform signal transmission with the first signal transceiver module 21 through the switch circuit 24 when the at least one first depletion-mode transistor and the at least one first enhancement-mode transistor are powered on. The second terminal B1 and the third terminal A2 are connected and the fourth terminal B2 and the fifth terminal A3 are disconnected when the switch circuit 24 is powered off, and the fourth terminal B2 and the fifth terminal A3 are connected when the at least one first depletion-mode transistor and the at least one first enhancement-mode transistor are powered on.

The second terminal B1 and the third terminal A2 are connected and the fourth terminal B2 and the fifth terminal A3 are disconnected when the switch circuit 24 is powered off. The at least one first depletion-mode transistor and the at least one first enhancement-mode transistor in the switch circuit 24 are powered on when a preset power-on condition is met. When the at least one first depletion-mode transistor and the at least one first enhancement-mode transistor are powered on, the second terminal B1 and the third terminal A2 are connected, and the fourth terminal B2 and the fifth terminal A3 are connected.

It should be noted that, for details about the switch circuit 24, refer to the descriptions of the switch circuit in the foregoing embodiment. Details are not described herein in this embodiment of this application again.

For example, as shown in FIG. 11B, in a scenario in which a plurality of communication modules are connected to a same antenna, the first signal transceiver module 21 in the switch application system 20 may be an antenna 31, the second signal transceiver module 22 may be a first WUR 32, and the third signal transceiver module 23 may be a first communication module 33. The preset power-on condition may include a case that the first communication module 33 enters an operating mode.

The first WUR 32 is configured to: receive a first wireless signal through the switch circuit 24 and the antenna 31 when the switch circuit 24 is powered off; and when the first wireless signal is a first wake-up signal, wake up the first communication module 33 in response to the first wake-up signal, so that the first communication module 33 enters the operating mode. The first communication module 33 is configured to: in the operating mode, control the at least one first depletion-mode transistor and the at least one first enhancement-mode transistor in the switch circuit 24 to be powered on, and receive a second wireless signal through the switch circuit 24 and the antenna 31.

Further, the first communication module 33 is further configured to enter a sleep state when a sleep condition is met. When the first communication module 33 is in the sleep state, the first communication module 33 may control the at least one first depletion-mode transistor and the at least one first enhancement-mode transistor to be powered off. The sleep condition may include a case of stopping receiving the second wireless signal within first duration or a case that first identification information is received, where the first identification information is used to indicate that transmission of the second wireless signal ends.

It can be understood that the first WUR 32 and the first communication module 33 multiplex the same antenna 31. When the first communication module 33 is in the sleep state, the first WUR 32 needs to listen to the first wireless signal. When the switch circuit 24 is powered off, the second terminal B1 and the third terminal A2 of the switch circuit 24 are connected, and the first terminal A1 and the third terminal A2 are also connected, so that the first WUR 32 is connected to the antenna 31 through the first terminal A1 and the fifth terminal A3 of the switch circuit 24, and the first WUR 32 can listen to the first wireless signal through the antenna 31. Because power consumption is small when the WUR performs wireless signal listening through the antenna 31, and there is no power consumption when the switch circuit 24 is powered off, power consumption in a process of performing wireless signal listening can be reduced.

For example, the first wireless signal received by the first WUR 32 may be a wake-up sequence. The first WUR 32 determines whether the received first wireless signal is the first wake-up signal, where the first wake-up signal is used to trigger wake-up for the first communication module. If the first wireless signal is the first wake-up signal, the first WUR 32 may generate a first wake-up frame, and send the first wake-up frame to the first communication module 33. The first communication module 33 receives the first wake-up frame and enters the operating mode in response to the first wake-up frame.

In some embodiments, the first communication module 33 may be electrically connected to a control terminal of the at least one first depletion-mode transistor, and the first communication module 33 may be further electrically connected to a control terminal of the at least one first enhancement-mode transistor. The first communication module 33 is specifically configured to: in the operating mode, output a first voltage value to the control terminal of the at least one first depletion-mode transistor, and output a second voltage value to the control terminal of the at least one first enhancement-mode transistor, so that the second terminal B1 and the third terminal A2 of the first switch sub-circuit are disconnected, and the fourth terminal B2 and the fifth terminal A3 of the second switch sub-circuit are connected. When the second terminal B1 and the third terminal A2 of the first switch sub-circuit are disconnected, the first terminal A1 and the third terminal A2 of the switch circuit 24 are also disconnected. When the fourth terminal B2 and the fifth terminal A3 of the second switch sub-circuit are connected, the first terminal A1 and the fifth terminal A3 of the switch circuit 24 are also connected.

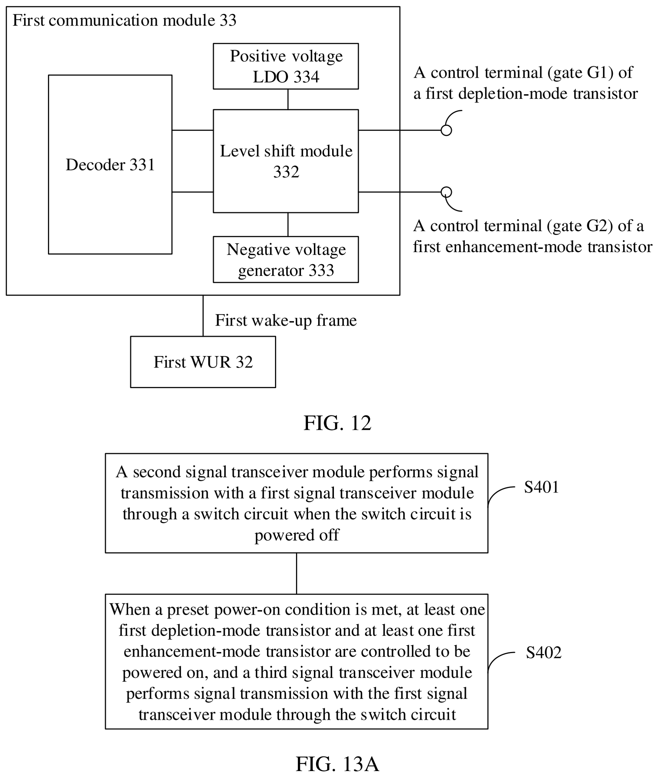

For example, with reference to the switch application system shown in FIG. 11B, FIG. 12 shows a first communication module according to an embodiment of this application. The first communication module 33 may include a decoder (decoder) 331, a level shift (level shift) module 332, a negative voltage generator 333, and a positive voltage low dropout regulator (low dropout regulator, LDO) 334. The level shift module 332 is electrically connected to the control terminal of the at least one first depletion-mode transistor (for example, a gate G1 of the at least one first depletion-mode transistor), and the level shift module 332 is further electrically connected to the control terminal of the at least one first enhancement-mode transistor (for example, a gate G2 of the at least one first enhancement-mode transistor).

A process in which the first communication module 33 shown in FIG. 12 controls the switch circuit 24 in the operating mode may include: s1. The first communication module 33 receives the first wake-up frame sent by the first WUR 32, and enters the operating mode in response to the first wake-up frame. s2. When the first communication module 33 enters the operating mode, various modules (including the decoder 331, the level shift module 332, the negative voltage generator 333, and the positive voltage LDO 334) of the first communication module 33 are powered on. s3. After the decoder 331 is powered on, a first initial signal (for example, 0 V) and a second initial signal (for example, 1.8 V) are generated in response to the first wake-up frame, and the first initial signal and the second initial signal are sent to the level shift module 332. s4. The level shift module 332 converts the first initial signal into the first voltage value by using the negative voltage generator 333 (for example, converts 0 V into -2.5 V), and outputs the first voltage value to the control terminal of the at least one first depletion-mode transistor. s5. The level shift module 332 further converts the second initial signal into the second voltage value by using the positive voltage LDO 334 (for example, converts 1.8 V into 2.5 V), and outputs the second voltage value to the control terminal of the at least one first enhancement-mode transistor.

In some embodiments, in addition to the at least one first depletion-mode transistor that is connected in series, the first switch sub-circuit may further include a first branch circuit. The first branch circuit includes at least one third enhancement-mode transistor that is connected in series. The first communication module 33 is electrically connected to a control terminal of the at least one third enhancement-mode transistor. Therefore, the first communication module 33 is further configured to: in the operating mode, output the second voltage value to the control terminal of the at least one third enhancement-mode transistor, so that a tenth terminal H1 and an eleventh terminal H2 of the first branch circuit are connected. The tenth terminal H1 and the eleventh terminal H2 of the first branch circuit are disconnected when the switch circuit 24 is powered off.

It should be noted that, for details about the first branch circuit, refer to the descriptions of the first branch circuit in the foregoing embodiment. Details are not described herein in this embodiment of this application again.

In some embodiments, in addition to the at least one first enhancement-mode transistor that is connected in series, the second switch sub-circuit may further include a second branch circuit. The second branch circuit includes at least one third depletion-mode transistor that is connected in series. The first communication module 33 is electrically connected to a control terminal of the at least one third depletion-mode transistor. Therefore, the first communication module 33 is further configured to: in the operating mode, output the first voltage value to the control terminal of the at least one third depletion-mode transistor, so that a twelfth terminal K1 and a thirteenth terminal K2 of the second branch circuit are disconnected. The twelfth terminal K1 and the thirteenth terminal K2 of the second branch circuit are connected when the switch circuit 24 is powered off.

It should be noted that, for details about the second branch circuit, refer to the descriptions of the second branch circuit in the foregoing embodiment. Details are not described herein in this embodiment of this application again.

In some embodiments, in the scenario in which a plurality of communication modules are connected to a same antenna, the switch application system 20 may further include a second WUR. The switch circuit 24 in the switch application system 20 may be the switch circuit shown in FIG. 7A or FIG. 7B, and the switch circuit 24 includes a first switch sub-circuit, a second switch sub-circuit, and a third switch sub-circuit. The first switch sub-circuit includes at least one first depletion-mode transistor, the second switch sub-circuit includes at least one first enhancement-mode transistor, and the third switch sub-circuit includes at least one second depletion-mode transistor. The seventh terminal A4 of the switch circuit 24 is electrically connected to the second WUR. The first communication module 33 may be electrically connected to a control terminal of the at least one first depletion-mode transistor, a control terminal of the at least one first enhancement-mode transistor, and a control terminal of the at least one second depletion-mode transistor.

The second WUR is configured to: receive a third wireless signal through the switch circuit and the antenna when the switch circuit is powered off; and when the third wireless signal is a third wake-up signal, wake up the first communication module 33 in response to the third wake-up signal, so that the first communication module 33 enters the operating mode.

The first communication module 33 is specifically configured to: in the operating mode, output the first voltage value to the control terminal of the at least one first depletion-mode transistor and the control terminal of the at least one second depletion-mode transistor, and output the second voltage value to the control terminal of the control terminal of the at least one first enhancement-mode transistor, so that the second terminal B1 and the third terminal A2 of the first switch sub-circuit are disconnected, the sixth terminal B3 and the seventh terminal A4 of the third switch sub-circuit are disconnected, and the fourth terminal B2 and the fifth terminal A3 of the second switch sub-circuit are connected. When the second terminal B1 and the third terminal A2 of the first switch sub-circuit are disconnected, the first terminal A1 and the third terminal A2 of the switch circuit 24 are also disconnected. When the sixth terminal B3 and the seventh terminal A4 of the third switch sub-circuit are disconnected, the first terminal A1 and the seventh terminal A4 of the switch circuit 24 are also disconnected. When the fourth terminal B2 and the fifth terminal A3 of the second switch sub-circuit are connected, the first terminal A1 and the fifth terminal A3 of the switch circuit 24 are also connected.

In some embodiments, in the scenario in which a plurality of communication modules are connected to a same antenna, the switch application system 20 may further include a second communication module. The switch circuit 24 in the switch application system 20 may be the switch circuit shown in FIG. 8A or FIG. 8B, and the switch circuit 24 includes a first switch sub-circuit, a second switch sub-circuit, and a fourth switch sub-circuit. The first switch sub-circuit includes at least one first depletion-mode transistor, the second switch sub-circuit includes at least one first enhancement-mode transistor, and the fourth switch sub-circuit includes at least one second enhancement-mode transistor that is connected in series. The fourth switch sub-circuit includes an eighth terminal B4 and a ninth terminal A5. The first terminal A1 of the switch circuit is electrically connected to the eighth terminal B4. The ninth terminal A5 of the switch circuit 24 is electrically connected to the second communication module. The second communication module may be electrically connected to a control terminal of the at least one first depletion-mode transistor and a control terminal of the at least one second enhancement-mode transistor.

The first WUR 32 is further configured to: when the first wireless signal is a second wake-up signal, wake up the second communication module in response to the second wake-up signal, so that the second communication module enters an operating mode. The second communication module is configured to: in the operating mode, control the at least one first depletion-mode transistor and the at least one second enhancement-mode transistor to be powered on, and receive the third wireless signal through the switch circuit 24 and the antenna 31.

The eighth terminal B4 and the ninth terminal A5 are disconnected when the switch circuit 24 is powered off. The eighth terminal B4 and the ninth terminal A5 are connected when the at least one first depletion-mode transistor and the at least one second enhancement-mode transistor are powered on.

For example, the second communication module outputs the first voltage value to the control terminal of the control terminal of the at least one first depletion-mode transistor, and outputs the second voltage value to the control terminal of the at least one second enhancement-mode transistor, so that the second terminal B1 and the third terminal A2 of the first switch sub-circuit are disconnected, and the eighth terminal B4 and the ninth terminal A5 of the fourth switch sub-circuit are connected. When the second terminal B1 and the third terminal A2 of the first switch sub-circuit are disconnected, the first terminal A1 and the third terminal A2 of the switch circuit 24 are also disconnected. When the eighth terminal B4 and the ninth terminal A5 of the fourth switch sub-circuit are connected, the first terminal A1 and the ninth terminal A5 of the switch circuit are also connected.

It should be noted that, for details about the second communication module (including a manner of waking up the second communication module, a sleep condition met by the second communication module, and the like), refer to the descriptions of the first communication module 33 in the foregoing embodiment. Details are not described herein in this embodiment of this application again.

It can be understood that the first WUR 32, the first communication module 33, and the second communication module may multiplex the same antenna 31. When both the first communication module 33 and the second communication module are in the sleep state, the first WUR 32 is connected to the antenna to listen to the first wireless signal. After the first WUR 32 wakes up the first communication module 33 or the second communication module, the first communication module 33 or the second communication module is connected to the antenna to perform wireless signal receiving/transmitting.

FIG. 13A shows a switch application method according to an embodiment of this application, which is applied to the foregoing switch application system. The method may include S401-S402.

S401: The second signal transceiver module performs signal transmission with the first signal transceiver module through the switch circuit when the switch circuit is powered off.

The first terminal A1 and the third terminal A2 of the switch circuit are connected when the switch circuit is powered off, so that the second signal transceiver module can be connected to the first signal transceiver module through the first terminal A1 and the third terminal A2 of the switch circuit. Therefore, the second signal transceiver module may perform signal transmission with the first signal transceiver module.

S402: When a preset power-on condition is met, the at least one first depletion-mode transistor and the at least one first enhancement-mode transistor are controlled to be powered on, and the third signal transceiver module performs signal transmission with the first signal transceiver module through the switch circuit.

When the preset power-on condition is met, the switch application system may output a first voltage value to the control terminal of the at least one first depletion-mode transistor, and output a second voltage value to the control terminal of the at least one first enhancement-mode transistor, so that the at least one first depletion-mode transistor is turned off, and the at least one first enhancement-mode transistor is turned on. The first terminal A1 and the third terminal A2 of the switch circuit are disconnected when the at least one first depletion-mode transistor is turned off. The first terminal A1 and the fifth terminal A3 of the switch circuit are connected when the at least one first enhancement-mode transistor is turned on. When the first terminal A1 and the fifth terminal A3 of the switch circuit are connected, the third signal transceiver module is connected to the first signal transceiver module through the first terminal A1 and the fifth terminal A3 of the switch circuit. Therefore, the third signal transceiver module may perform signal transmission with the first signal transceiver module.

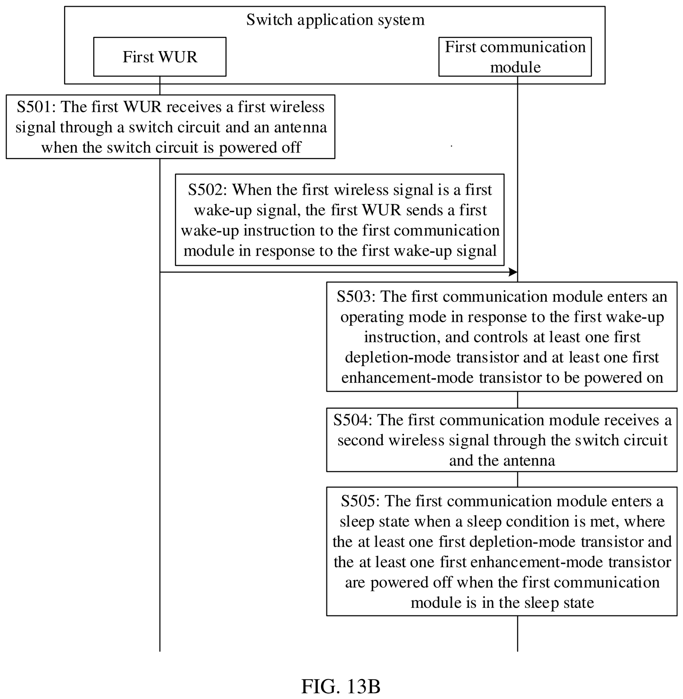

For example, a scenario in which a plurality of communication modules are connected to a same antenna is used as an example to describe the switch application method provided in this embodiment of this application. As shown in FIG. 13B, S401 in the method may include S501, and S402 may include S503-S504. The method may further include S502 and S505.

S501: The first WUR receives a first wireless signal through the switch circuit and the antenna when the switch circuit is powered off.

The first terminal A1 and the third terminal A2 of the switch circuit are connected when the switch circuit is powered off, so that the first WUR can be connected to the antenna through the first terminal A1 and the third terminal A2 of the switch circuit. Therefore, the first WUR receives the first wireless signal (for example, a radio frequency signal) through the antenna.

S502: When the first wireless signal is a first wake-up signal, the first WUR sends a first wake-up instruction to the first communication module in response to the first wake-up signal.

After receiving the first wireless signal, the first WUR determines whether the first wireless signal is the first wake-up signal. If the first wireless signal is the first wake-up signal, the first WUR sends the first wake-up instruction (for example, a first wake-up frame) to the first communication module in response to the first wake-up signal.

S503: The first communication module enters an operating mode in response to the first wake-up instruction, and controls the at least one first depletion-mode transistor and the at least one first enhancement-mode transistor to be powered on, so that the first terminal A1 and the third terminal A2 of the switch circuit are disconnected and the first terminal A1 and the fifth terminal A3 of the switch circuit are connected.

The first communication module enters the operating mode from a sleep state in response to the first wake-up instruction. In the operating mode, the first communication module outputs the first voltage value to the control terminal of the at least one first depletion-mode transistor, and outputs the second voltage value to the control terminal of the at least one first enhancement-mode transistor, so that the at least one first depletion-mode transistor is turned off, and the at least one first enhancement-mode transistor is turned on. The first terminal A1 and the third terminal A2 of the switch circuit are disconnected when the at least one first depletion-mode transistor is turned off. The first terminal A1 and the fifth terminal A3 of the switch circuit are connected when the at least one first enhancement-mode transistor is turned on.

S504: The first communication module receives a second wireless signal through the switch circuit and the antenna.

When the first terminal A1 and the fifth terminal A3 of the switch circuit are connected, the first communication module is connected to the antenna through the first terminal A1 and the fifth terminal A3 of the switch circuit. Therefore, the first communication module may perform wireless signal receiving/transmitting through the antenna.

S505: The first communication module enters the sleep state when a sleep condition is met, where the at least one first depletion-mode transistor and the at least one first enhancement-mode transistor are powered off when the first communication module is in the sleep state.

After entering the sleep state, the first communication module stops supplying power to the at least one first depletion-mode transistor and the at least one first enhancement-mode transistor, that is, both the at least one first depletion-mode transistor and the at least one first enhancement-mode transistor are powered off. When both the at least one first depletion-mode transistor and the at least one first enhancement-mode transistor are powered off, the first terminal A1 and the third terminal A2 of the switch circuit are disconnected, and the first terminal A1 and the fifth terminal A3 of the switch circuit are connected. Therefore, the first WUR is connected to the antenna through the first terminal A1 and the third terminal A2 of the switch circuit, and continues to perform wireless signal listening.

In some embodiments, a scenario in which a plurality of signal sources are connected to a same electronic device may include: an antenna and a multimedia player (for example, a digital video disc (Digital Video Disk, DVD) or a video compact disc (Video Compact Disc, VCD)) are connected to a same television set.

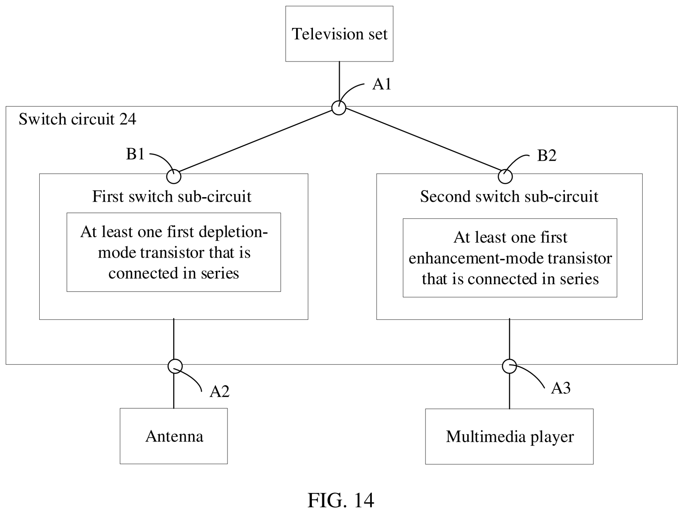

For example, in the scenario in which the antenna and the multimedia player are connected to the same television set, as shown in FIG. 14, the first signal transceiver module 21 in the switch application system 20 may be the television set, the second signal transceiver module 22 may be the antenna, and the third signal transceiver module 23 may be the multimedia player. The first terminal A1 of the switch circuit 24 may be configured to be electrically connected to the television set, the third terminal A2 of the switch circuit 24 may be configured to be electrically connected to the antenna, and the fifth terminal A3 of the switch circuit 24 may be configured to be electrically connected to the multimedia player. The preset power-on condition may include a switching operation, and the switching operation is used to trigger switching for a signal source of the television set.

The television set is configured to: when the switch circuit 24 is powered off, receive a first signal through the switch circuit 24 and the antenna, and display first multimedia information according to the first signal; and receive the switching operation, control, in response to the switching operation, the at least one first depletion-mode transistor and the at least one first enhancement-mode transistor to be powered on, receive a second signal through the switch circuit 24 and the multimedia player, and display second multimedia information according to the second signal.

It can be understood that the first terminal A1 and the third terminal A2 of the switch circuit are connected and the first terminal A1 and the fifth terminal A3 of the switch circuit are disconnected when the switch circuit is powered off. Therefore, it can be learned that the television set is connected to the antenna and the television set is disconnected from the multimedia player when the switch circuit is powered off.

It can be understood that, to implement the foregoing functions, the switch application system includes corresponding hardware structures and/or software modules for performing the functions. A person skilled in the art may be easily aware that, in combination with example units and algorithm steps described in the embodiments disclosed in this specification, the embodiments of this application can be implemented by hardware or a combination of hardware and computer software. Whether a specific function is performed by hardware or hardware driven by computer software depends on a particular application and a design constraint of the technical solutions. A person skilled in the art may use different methods to implement the described functions for each particular application, but it should not be considered that the implementation goes beyond the scope of the embodiments of this application.

An embodiment of this application further provides a communication device. The communication device includes the switch application system described in the foregoing embodiment and/or the switch circuit described in the foregoing embodiment.

In some examples, the communication device may be an electronic device having a communication function, for example, a mobile phone, a tablet computer, a handheld computer, a personal computer (personal computer, PC), a personal digital assistant (personal digital assistant, PDA), or a wearable device. A specific form of the electronic device is not limited herein in embodiments of this application.

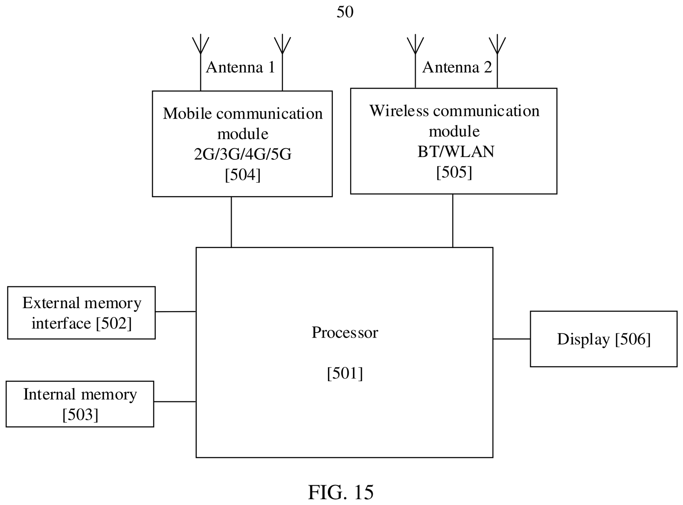

For example, the communication device is a mobile phone. FIG. 15 is a schematic diagram of a structure of a communication device according to an embodiment of this application.

As shown in FIG. 15, a mobile phone 50 may include a processor 501, an external memory interface 502, an internal memory 503, an antenna 1, an antenna 2, a mobile communication module 504, a wireless communication module 505, a display 506, and the like.

It can be understood that the structure illustrated in the embodiments does not constitute a specific limitation on the mobile phone 50. In some other embodiments, the mobile phone 50 may include more or fewer components than those shown in the figure, or some components may be combined, or some components may be split, or components are arranged in different manners. The parts shown in the figure may be implemented by hardware, software, or a combination of software and hardware.

The processor 501 may be a nerve center and a command center of the mobile phone 50. The processor 501 may generate an operation control signal based on instruction operation code and a timing signal, to complete control of instruction fetching and instruction execution.

A memory may be disposed in the processor 501, to store instructions and data. In some embodiments, the memory in the processor 501 is a cache memory. The memory may store instructions or data just used or cyclically used by the processor 501. If the processor 501 needs to use the instructions or the data again, the processor 501 may directly invoke the instructions or the data from the memory. This avoids repeated access and reduces waiting time of the processor 501, thereby improving working efficiency of the processor 501.

A wireless communication function of the mobile phone 50 may be implemented by using the antenna 1, the antenna 2, the mobile communication module 504, the wireless communication module 505, a modem processor, a baseband processor, and the like.

The antenna 1 and the antenna 2 are configured to transmit and receive electromagnetic wave signals. Each antenna in the mobile phone 50 may be configured to cover one or more communication frequency bands. Different antennas may be further multiplexed to improve antenna utilization. For example, the antenna 1 may be multiplexed as a diversity antenna of a wireless local area network.

The mobile communication module 504 may provide a solution to wireless communication such as 2G/3G/4G/5G applied to the mobile phone 50. The mobile communication module 504 may include at least one filter, at least one switch, at least one power amplifier, at least one low noise amplifier (low noise amplifier, LNA), and the like. The mobile communication module 504 may receive an electromagnetic wave through the antenna 1, perform processing such as filtering or amplification on the received electromagnetic wave, and transmit a processed electromagnetic wave to the modem processor for demodulation. The mobile communication module 504 may further amplify a signal obtained after modulation by the modem processor, and convert, through the antenna 1, an amplified signal into an electromagnetic wave for radiation. In some embodiments, at least some functional modules in the mobile communication module 504 may be disposed in the processor 501. In some embodiments, at least some functional modules of the mobile communication module 504 may be disposed in a same device as at least some modules of the processor 501.

The wireless communication module 505 can provide a solution to wireless communication such as wireless local area networks (wireless local area networks, WLAN) and BT applied to the mobile phone 50. The wireless communication module 505 may be one or more devices integrating at least one communication processing module. The wireless communication module 505 receives an electromagnetic wave through the antenna 2, performs frequency modulation and filtering processing on an electromagnetic wave signal, and sends a processed signal to the processor 501. The wireless communication module 505 may further receive a to-be-sent signal from the processor 501, perform frequency modulation and amplification on the to-be-sent signal, and convert, through the antenna 2, the to-be-sent signal into an electromagnetic wave for radiation.

In some embodiments, in the mobile phone 50, the antenna 1 is coupled to the mobile communication module 504, and the antenna 2 is coupled to the wireless communication module 505, so that the mobile phone 50 can communicate with a network and another device (for example, a server) by using a wireless communication technology. The wireless communication technology may include a global system for mobile communications (global system for mobile communications, GSM), BT, WLAN, and/or the like.

The external memory interface 502 may be configured to be connected to an external memory card such as a Micro SD card, to extend a storage capability of the mobile phone 50. The internal memory 503 may be configured to store computer-executable program code, and the executable program code includes computer instructions. The processor 501 runs the computer instructions stored in the internal memory 503, to perform various function applications and data processing of the mobile phone 50.

Certainly, it can be understood that FIG. 15 is merely an example for description that is used when a form of the communication device is a mobile phone. If the communication device is in another device form, for example, a tablet computer, a handheld computer, a PC, a PDA, or a wearable device, the structure of the communication device may include fewer structures than those shown in FIG. 15 or may include more structures than those shown in FIG. 15. This is not limited herein.

An embodiment of this application further provides a communication device. The communication device includes a processor, a memory, a communication interface, and a communication bus. The processor, the memory, and the communication interface communicate with each other through the communication bus. The memory is configured to store computer instructions. When the processor executes the computer instructions, the communication device is enabled to perform the functions or steps performed by the communication device in the foregoing method embodiment.

An embodiment of this application further provides a computer-readable storage medium. The computer-readable storage medium stores computer instructions. When the computer instructions are run on a communication device, the communication device is enabled to perform the functions or steps performed by the communication device in the foregoing method embodiment.

For example, the computer-readable storage medium may be a read-only memory (Read-Only Memory, ROM), a random access memory (Random Access Memory, RAM), a compact disc read-only memory (Compact Disc Read-Only Memory, CD-ROM), a magnetic tape, a floppy disk, an optical data storage device, or the like.

An embodiment of this application further provides a computer program product including computer instructions. When the computer instructions are run on a communication device, the communication device is enabled to perform the functions or steps performed by the communication device in the foregoing method embodiment.

The communication device, the computer-readable storage medium, or the computer program product provided in the embodiments of this application may be configured to perform the corresponding method provided above. Therefore, for beneficial effects that can be achieved by the communication device, the computer-readable storage medium, or the computer program product, refer to the beneficial effects of the corresponding method provided above. Details are not described herein again.

Through the descriptions of the foregoing implementations, a person skilled in the art may clearly understand that, for the purpose of convenient and brief description, only division of the foregoing functional modules is used as an example for description. In actual application, the functions may be allocated to and completed by different functional modules based on a requirement. In other words, an internal structure of an apparatus (for example, a communication device) is divided into different functional modules, to complete all or some of the functions described above. For specific operating processes of the system, apparatus (for example, the communication device), and unit described above, refer to corresponding processes in the foregoing method embodiment. Details are not described herein again.

In the several embodiments provided in this application, it should be understood that the disclosed system, apparatus (for example, the communication device), and method may be implemented in another manner. For example, the described apparatus (for example, the communication device) embodiment is merely an example. For example, the module or unit division is merely logical function division and may be another division in actual implementation. For example, a plurality of units or components may be combined or integrated into another system, or some features may be ignored or not performed.

The units described as separate components may or may not be physically separated, and components displayed as units may or may not be physical units, in other words, may be located in one place, or may be distributed on a plurality of network units. Some or all of the units may be selected based on actual requirements to achieve the objectives of the solutions in embodiments.

In addition, the functional units in the embodiments of this application may be integrated into one processing unit, each of the units may exist alone physically, or two or more units may be integrated into one unit. The integrated unit may be implemented in a form of hardware, or may be implemented in a form of a software functional unit.

When the integrated unit is implemented in the form of the software functional unit and sold or used as an independent product, the integrated unit may be stored in a computer-readable storage medium. Based on such an understanding, the technical solutions of this application essentially, or the part contributing to the conventional technology, or all or some of the technical solutions may be implemented in a form of a software product. The computer software product is stored in a storage medium and includes several instructions for instructing a computer device (which may be a personal computer, a server, a network device, or the like) or a processor to perform all or some of the steps of the methods described in the embodiments of this application. The storage medium includes any medium that can store program code, for example, a flash memory, a removable hard disk, a read-only memory, a random access memory, a magnetic disk, or an optical disc.

The foregoing descriptions are merely specific implementations of this application, but are not intended to limit the protection scope of this application. Any person skilled in the art can readily figure out variations or replacements within the technical scope disclosed in this application, and these variations or replacements shall fall within the protection scope of this application. Therefore, the protection scope of this application shall be subject to the protection scope of the claims.

## Claims

1. A switch circuit, wherein the switch circuit comprises a first switch sub-circuit and a second switch sub-circuit that are connected in parallel, the first switch sub-circuit comprises at least one first depletion-mode transistor that is connected in series, the second switch sub-circuit comprises at least one first enhancement-mode transistor that is connected in series, the switch circuit comprises a first terminal, the first switch sub-circuit comprises a second terminal and a third terminal, the second switch sub-circuit comprises a fourth terminal and a fifth terminal, the first terminal is electrically connected to the second terminal, and the first terminal is electrically connected to the fourth terminal; and
the second terminal and the third terminal are connected and the fourth terminal and the fifth terminal are disconnected when the switch circuit is powered off.

2. The switch circuit according to claim 1, wherein when a voltage at a control terminal of the at least one first depletion-mode transistor is a first voltage value and a voltage at a control terminal of the at least one first enhancement-mode transistor is a second voltage value, the second terminal and the third terminal are disconnected, and the fourth terminal and the fifth terminal are connected.

3. The switch circuit according to claim 1 or 2, wherein the first terminal is configured to be electrically connected to an antenna, the third terminal is configured to be electrically connected to a first wake-up receiver WUR, and the fifth terminal is configured to be electrically connected to a first communication module.

4. The switch circuit according to claim 1 or 2, wherein the first terminal is configured to be electrically connected to a television set, the third terminal is configured to be electrically connected to an antenna, and the fifth terminal is configured to be electrically connected to a multimedia player.

5. The switch circuit according to claim 3, wherein the switch circuit further comprises a third switch sub-circuit, the third switch sub-circuit is connected in parallel to the first switch sub-circuit and the second switch sub-circuit, the third switch sub-circuit comprises a sixth terminal and a seventh terminal, the first terminal is electrically connected to the sixth terminal, and the third switch sub-circuit comprises at least one second depletion-mode transistor that is connected in series; and
the sixth terminal and the seventh terminal are connected when the switch circuit is powered off, and the sixth terminal and the seventh terminal are disconnected when a voltage at a control terminal of the at least one second depletion-mode transistor is the first voltage value.

6. The switch circuit according to claim 5, wherein the seventh terminal is configured to be electrically connected to a second WUR, and an operating frequency band of the second WUR is different from that of the first WUR.

7. The switch circuit according to claim 3, wherein the switch circuit further comprises a fourth switch sub-circuit, the fourth switch sub-circuit is connected in parallel to the first switch sub-circuit and the second switch sub-circuit, the fourth switch sub-circuit comprises an eighth terminal and a ninth terminal, the first terminal is electrically connected to the eighth terminal, and the fourth switch sub-circuit comprises at least one second enhancement-mode transistor that is connected in series; and
the eighth terminal and the ninth terminal are disconnected when the switch circuit is powered off, and the eighth terminal and the ninth terminal are connected when a voltage at a control terminal of the at least one second enhancement-mode transistor is the second voltage value.

8. The switch circuit according to claim 7, wherein the ninth terminal is configured to be electrically connected to a second communication module.

9. The switch circuit according to any one of claims 1-8, wherein the first switch sub-circuit comprises a first branch circuit, the first branch circuit comprises at least one third enhancement-mode transistor that is connected in series, the first branch circuit comprises a tenth terminal and an eleventh terminal, the tenth terminal is electrically connected to the first switch sub-circuit, and the eleventh terminal is grounded; and
the tenth terminal and the eleventh terminal are disconnected when the switch circuit is powered off, and the tenth terminal and the eleventh terminal are connected when a voltage at a control terminal of the at least one third enhancement-mode transistor is the second voltage value.

10. The switch circuit according to any one of claims 1-9, wherein the second switch sub-circuit comprises a second branch circuit, the second branch circuit comprises at least one third depletion-mode transistor that is connected in series, the second branch circuit comprises a twelfth terminal and a thirteenth terminal, the twelfth terminal is electrically connected to the second switch sub-circuit, and the second terminal of the second branch circuit is grounded; and
the twelfth terminal and the thirteenth terminal are connected when the switch circuit is powered off, and the twelfth terminal and the thirteenth terminal are disconnected when a voltage at a control terminal of the at least one third depletion-mode transistor is the first voltage value.

11. A switch application system, wherein the switch application system comprises a first signal transceiver module, a second signal transceiver module, a third signal transceiver module, and a switch circuit, and the switch circuit comprises a first terminal;
the switch circuit comprises a first switch sub-circuit and a second switch sub-circuit that are connected in parallel, the first switch sub-circuit comprises at least one first depletion-mode transistor that is connected in series, the second switch sub-circuit comprises at least one first enhancement-mode transistor that is connected in series, the first switch sub-circuit comprises a second terminal and a third terminal, the second switch sub-circuit comprises a fourth terminal and a fifth terminal, the first terminal is electrically connected to the second terminal, the first terminal is electrically connected to the fourth terminal, the first terminal is electrically connected to the first signal transceiver module, the third terminal is electrically connected to the second signal transceiver module, and the fifth terminal is electrically connected to the third signal transceiver module;
the second signal transceiver module is configured to perform signal transmission with the first signal transceiver module through the switch circuit when the switch circuit is powered off; and
the third signal transceiver module is configured to perform signal transmission with the first signal transceiver module through the switch circuit when the at least one first depletion-mode transistor and the at least one first enhancement-mode transistor are powered on, wherein
the second terminal and the third terminal are connected and the fourth terminal and the fifth terminal are disconnected when the switch circuit is powered off, the at least one first depletion-mode transistor and the at least one first enhancement-mode transistor are powered on when a preset power-on condition is met, and the fourth terminal and the fifth terminal are connected when the at least one first depletion-mode transistor and the at least one first enhancement-mode transistor are powered on.

12. The switch application system according to claim 11, wherein the first signal transceiver module is an antenna, the second signal transceiver module is a first wake-up receiver WUR, the third signal transceiver module is a first communication module, and the preset power-on condition comprises a case that the first communication module enters an operating mode;
the first WUR is configured to: receive a first wireless signal through the switch circuit and the antenna when the switch circuit is powered off; and when the first wireless signal is a first wake-up signal, wake up the first communication module in response to the first wake-up signal, so that the first communication module enters the operating mode; and
the first communication module is configured to: in the operating mode, control the at least one first depletion-mode transistor and the at least one first enhancement-mode transistor to be powered on, and receive a second wireless signal through the switch circuit and the antenna.

13. The switch application system according to claim 11, wherein the first signal transceiver module is a television set, the second signal transceiver module is an antenna, the third signal transceiver module is a multimedia player, the preset power-on condition comprises a switching operation, and the switching operation is used to trigger switching for a signal source of the television set; and
the television set is configured to: when the switch circuit is powered off, receive a first signal through the switch circuit and the antenna, and display first multimedia information according to the first signal; and receive the switching operation, control, in response to the switching operation, the at least one first depletion-mode transistor and the at least one first enhancement-mode transistor to be powered on, receive a second signal through the switch circuit and the multimedia player, and display second multimedia information according to the second signal.

14. The switch application system according to claim 12, wherein the first communication module is electrically connected to a control terminal of the at least one first depletion-mode transistor, and the first communication module is electrically connected to a control terminal of the at least one first enhancement-mode transistor; and
the first communication module is specifically configured to: in the operating mode, output a first voltage value to the control terminal of the at least one first depletion-mode transistor, and output a second voltage value to the control terminal of the at least one first enhancement-mode transistor, so that the second terminal and the third terminal are disconnected, and the fourth terminal and the fifth terminal are connected.

15. The switch application system according to claim 14, wherein the first communication module is further configured to enter a sleep state when a sleep condition is met, wherein the at least one first depletion-mode transistor and the at least one first enhancement-mode transistor are powered off when the first communication module is in the sleep state.

16. The switch application system according to any one of claims 12, 14, and 15, wherein the switch circuit further comprises a third switch sub-circuit, the third switch sub-circuit is connected in parallel to the first switch sub-circuit and the second switch sub-circuit, the third switch sub-circuit comprises a sixth terminal and a seventh terminal, the first terminal is electrically connected to the sixth terminal, and the third switch sub-circuit comprises at least one second depletion-mode transistor that is connected in series; and
the sixth terminal and the seventh terminal are connected when the switch circuit is powered off.

17. The switch application system according to claim 16, wherein the switch application system further comprises a second WUR, the seventh terminal is electrically connected to the second WUR, and an operating frequency band of the second WUR is different from that of the first WUR; and
the second WUR is configured to: receive a third wireless signal through the switch circuit and the antenna when the switch circuit is powered off; and when the third wireless signal is a third wake-up signal, wake up the first communication module in response to the third wake-up signal, so that the first communication module enters the operating mode.

18. The switch application system according to claim 16 or 17, wherein the first communication module is electrically connected to the control terminal of the at least one first depletion-mode transistor, the first communication module is electrically connected to the control terminal of the at least one first enhancement-mode transistor, and the first communication module is electrically connected to a control terminal of the at least one second depletion-mode transistor; and
the first communication module is specifically configured to: in the operating mode, output the first voltage value to the control terminal of the at least one first depletion-mode transistor and the control terminal of the at least one second depletion-mode transistor, and output the second voltage value to the control terminal of the control terminal of the at least one first enhancement-mode transistor, so that the second terminal and the third terminal are disconnected, the sixth terminal and the seventh terminal are disconnected, and the fourth terminal and the fifth terminal are connected.

19. The switch application system according to any one of claims 12 and 14-18, wherein the switch application system further comprises a second communication module, the switch circuit further comprises a fourth switch sub-circuit, the fourth switch sub-circuit is connected in parallel to the first switch sub-circuit and the second switch sub-circuit, the fourth switch sub-circuit comprises an eighth terminal and a ninth terminal, the first terminal is electrically connected to the eighth terminal, the ninth terminal is electrically connected to the second communication module, and the fourth switch sub-circuit comprises at least one second enhancement-mode transistor that is connected in series;
the first WUR is further configured to: when the first wireless signal is a second wake-up signal, wake up the second communication module in response to the second wake-up signal, so that the second communication module enters an operating mode; and
the second communication module is configured to: in the operating mode, control the at least one first depletion-mode transistor and the at least one second enhancement-mode transistor to be powered on, and receive the third wireless signal through the switch circuit and the antenna, wherein
the eighth terminal and the ninth terminal are disconnected when the switch circuit is powered off, and the eighth terminal and the ninth terminal are connected when the at least one first depletion-mode transistor and the at least one second enhancement-mode transistor are powered on.

20. The switch application system according to any one of claims 12 and 14-19, wherein the first switch sub-circuit comprises a first branch circuit, the first branch circuit comprises at least one third enhancement-mode transistor that is connected in series, the first branch circuit comprises a tenth terminal and an eleventh terminal, the tenth terminal is electrically connected to the first switch sub-circuit, the eleventh terminal is grounded, and the first communication module is electrically connected to a control terminal of the at least one third enhancement-mode transistor; and
the first communication module is further configured to: in the operating mode, output the second voltage value to the control terminal of the at least one third enhancement-mode transistor, so that the tenth terminal and the eleventh terminal are connected, wherein
the tenth terminal and the eleventh terminal are disconnected when the switch circuit is powered off.

21. The switch application system according to any one of claims 12 and 14-20, wherein the second switch sub-circuit comprises a second branch circuit, the second branch circuit comprises at least one third depletion-mode transistor that is connected in series, the second branch circuit comprises a twelfth terminal and a thirteenth terminal, the twelfth terminal is electrically connected to the second switch sub-circuit, the thirteenth terminal is grounded, and the first communication module is electrically connected to a control terminal of the at least one third depletion-mode transistor; and
the first communication module is further configured to: in the operating mode, output the first voltage value to the control terminal of the at least one third depletion-mode transistor, so that the twelfth terminal and the thirteenth terminal are disconnected, wherein
the twelfth terminal and the thirteenth terminal are connected when the switch circuit is powered off.

22. A communication device, wherein the communication device comprises the switch application system according to any one of claims 11, 12, and 14-21 and/or the switch circuit according to any one of claims 1-10.

23. A switch application method, applied to a switch application system, wherein the switch application system comprises a first signal transceiver module, a second signal transceiver module, a third signal transceiver module, and a switch circuit, the switch circuit comprises a first terminal, the switch circuit comprises a first switch sub-circuit and a second switch sub-circuit that are connected in parallel, the first switch sub-circuit comprises at least one first depletion-mode transistor that is connected in series, the second switch sub-circuit comprises at least one first enhancement-mode transistor that is connected in series, the first switch sub-circuit comprises a second terminal and a third terminal, the second switch sub-circuit comprises a fourth terminal and a fifth terminal, the first terminal is electrically connected to the second terminal, the first terminal is electrically connected to the fourth terminal, the first terminal is electrically connected to the first signal transceiver module, the third terminal is electrically connected to the second signal transceiver module, and the fifth terminal is electrically connected to the third signal transceiver module; and
the method comprises:
performing, by the second signal transceiver module, signal transmission with the first signal transceiver module through the switch circuit when the switch circuit is powered off; and
controlling, when a preset power-on condition is met, the at least one first depletion-mode transistor and the at least one first enhancement-mode transistor to be powered on, and performing, by the third signal transceiver module, signal transmission with the first signal transceiver module through the switch circuit, wherein
the second terminal and the third terminal are connected and the fourth terminal and the fifth terminal are disconnected when the switch circuit is powered off, and the fourth terminal and the fifth terminal are connected when the at least one first depletion-mode transistor and the at least one first enhancement-mode transistor are powered on.

24. The method according to claim 23, wherein the first signal transceiver module is an antenna, the second signal transceiver module is a first wake-up receiver WUR, the third signal transceiver module is a first communication module, and the preset power-on condition comprises a case that the first communication module enters an operating mode; and
the method comprises:
receiving, by the first WUR, a first wireless signal through the switch circuit and the antenna when the switch circuit is powered off, and sending, when the first wireless signal is a first wake-up signal, a first wake-up instruction to the first communication module in response to the first wake-up signal;
entering, by the first communication module, the operating mode in response to the first wake-up instruction, and controlling the at least one first depletion-mode transistor and the at least one first enhancement-mode transistor to be powered on, so that the second terminal and the third terminal are disconnected, and the fourth terminal and the fifth terminal are connected; and
receiving, by the first communication module, a second wireless signal through the switch circuit and the antenna.

25. The method according to claim 24, wherein the method further comprises:
entering, by the first communication module, a sleep state when a sleep condition is met, wherein the at least one first depletion-mode transistor and the at least one first enhancement-mode transistor are powered off when the first communication module is in the sleep state.

26. The method according to claim 23, wherein the first signal transceiver module is a television set, the second signal transceiver module is an antenna, the third signal transceiver module is a multimedia player, the preset power-on condition comprises a switching operation, and the switching operation is used to trigger switching for a signal source of the television set; and
the method comprises:
receiving, by the television set when the switch circuit is powered off, a first signal through the switch circuit and the antenna, and displaying first multimedia information according to the first signal;
receiving, by the television set, the switching operation, controlling, in response to the switching operation, the at least one first depletion-mode transistor and the at least one first enhancement-mode transistor to be powered on, and receiving a second signal through the switch circuit and the multimedia player; and
displaying, by the television set, the second multimedia information according to the second signal.

27. A communication device, wherein the communication device comprises a processor, a memory, a communication interface, and a communication bus; the processor, the memory, and the communication interface communicate with each other through the communication bus; the memory is configured to store computer instructions; and when the computer instructions are run on the processor, the processor is enabled to perform the switch application method according to any one of claims 23-26.

28. A computer-readable storage medium, wherein the computer-readable storage medium stores computer instructions; and when the computer instructions are run on a communication device, the communication device is enabled to perform the switch application method according to any one of claims 23-26.
